(19) **Europäisches Patentamt / European Patent Office / Office européen des brevets**

(11) **EP 3 948 957 B1**

(12) **FASCICULE DE BREVET EUROPEEN**

(45) Date de publication et mention de la délivrance du brevet:
**08.10.2025 Bulletin 2025/41**

(21) Numéro de dépôt: **20713916.3**

(22) Date de dépôt: **31.03.2020**

(51) Classification Internationale des Brevets (IPC):
**H10F 19/90** (2025.01)    **H10F 77/20** (2025.01)

(52) Classification Coopérative des Brevets (CPC):
**H10F 77/215; H10F 19/904; H10F 77/219;**
Y02E 10/50

(86) Numéro de dépôt international:
**PCT/EP2020/059140**

(87) Numéro de publication internationale:
**WO 2020/201290 (08.10.2020 Gazette 2020/41)**

(54) **CELLULE ET CHAÎNE PHOTOVOLTAÏQUES ET PROCÉDÉS ASSOCIÉS**

FOTOVOLTAISCHE ZELLE SOWIE STRANG UND ZUGEHÖRIGE VERFAHREN

PHOTOVOLTAIC CELL AND STRING AND ASSOCIATED METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.04.2019 FR 1903460**

(43) Date de publication de la demande:
**09.02.2022 Bulletin 2022/06**

(73) Titulaire: **Commissariat à l'Energie Atomique et aux Energies Alternatives**
**75015 Paris (FR)**

(72) Inventeur: **BETTINELLI, Armand**
**38054 GRENOBLE CEDEX 09 (FR)**

(74) Mandataire: **Cabinet Camus Lebkiri**
**25 rue de Maubeuge**
**75009 Paris (FR)**

(56) Documents cités:
**EP-A1- 3 002 792      EP-A1- 3 331 028**
**EP-A1- 3 361 513      CN-U- 207 367 985**
**KR-A- 20190 025 099   US-A1- 2017 194 516**
**US-A1- 2019 097 073**

• **T SÖDERSTRÖM ET AL: "Smart Wire Connection Technology", ENERGY PROCEDIA, 1 January 2013 (2013-01-01), NL, pages 495 - 499, XP055271426, ISSN: 1876-6102**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

## DOMAINE TECHNIQUE

La présente invention est relative à une cellule photovoltaïque, à une chaîne de cellules photovoltaïques, dans laquelle les cellules photovoltaïques se recouvrent partiellement, et à leurs procédés de fabrication respectifs.

## ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six « chaînes » (« strings » en anglais) de dix cellules connectées en série. Les six chaînes de cellules photovoltaïques sont également connectées en série.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites (<100 $\mu$m). Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

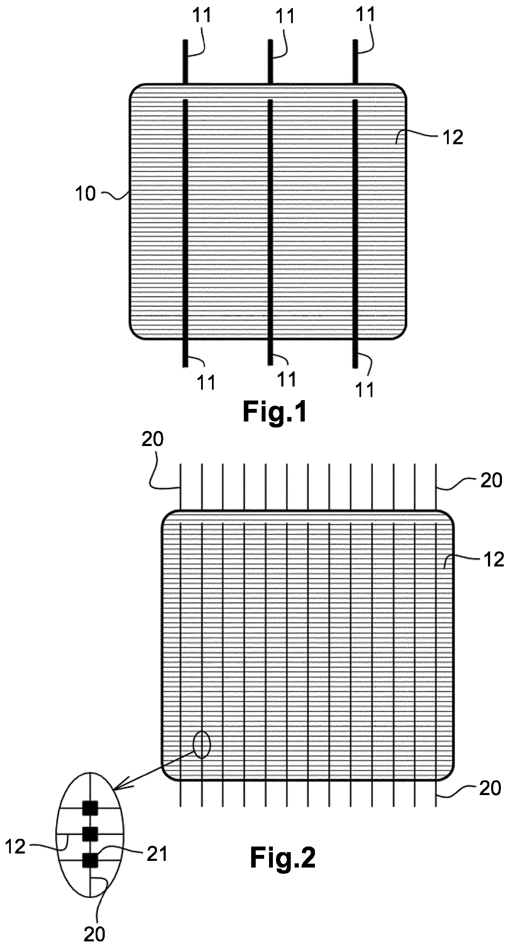

On distingue aujourd'hui deux techniques majeures pour interconnecter les cellules photovoltaïques d'une chaîne : les interconnexions en forme de ruban et les interconnexions en forme de fil électrique. Ces deux techniques sont représentées par les figures 1 et 2 respectivement.

Sur la figure 1, les interconnexions entre les cellules 10 sont constituées de rubans 11 en cuivre recouverts d'un alliage fusible, typiquement un alliage d'étain et de plomb ou un alliage d'étain et d'argent. Ces rubans 11 de section rectangulaire sont soudés sur des pistes conductrices appelées « busbars » et formées en même temps que les doigts de collecte 12 par sérigraphie. Les busbars relient électriquement les doigts de collecte 12 et sont orientés perpendiculairement aux doigts de collecte 12.

Une cellule de 156 mm x 156 mm compte généralement trois rubans de 1,5 mm de large ou quatre rubans de 1,2 mm de large, ces rubans ayant une épaisseur de l'ordre de 0,2 mm. Chaque ruban 11 connecte la face avant d'une cellule 10 à la face arrière de la cellule suivante dans la chaîne (non représentée sur la figure 1). La connexion en série des cellules photovoltaïques 10 au moyen des rubans 11 s'effectue de façon entièrement automatisée, dans un équipement appelé « stringer ».

Plusieurs équipementiers proposent dorénavant de remplacer les rubans de cuivre par des fils électriques de plus faible section. Par exemple, la technologie « Multi-Busbar » développée par la société « Schmid » et décrite dans l'article [« Multi-busbar solar cells and modules: high efficiencies and low silver consumption », S. Braun et al., Energy Procedia, vol. 38, pp. 334-339, 2013] multiplie le nombre de busbars déposés sur la cellule, passant de trois à quinze busbars, et soude à chaque busbar un fil de 200 $\mu$m de diamètre. Cette technologie est schématisée sur la figure 2. Les fils 20 sont constitués de cuivre et recouverts d'une fine couche d'un alliage à base d'étain-plomb ou d'étain-argent dont le point de fusion est situé au-dessus de 170 °C. Les busbars ont une forme discontinue. Ils se composent de plots de métallisation 21, d'environ 500 $\mu$m x 700 $\mu$m, alignés sur les doigts de collecte 12. Les plots de métallisation 21 et les doigts de collecte 12 sont généralement réalisés par sérigraphie d'une pâte d'argent. La soudure des fils 20 sur les plots 21 a lieu immédiatement après avoir posé les fils sur les plots, dans le même équipement, en chauffant ces éléments à une température de l'ordre de 200 °C. Ainsi, l'alliage recouvrant les fils de cuivre est fondu.

La technologie « SmartWire » développée par la société « Meyer Burger » et décrite dans l'article [« Smart Wire Connection Technology », T. Söderström et al., Proceedings of the 28th European Photovoltaics Solar Energy Conference, pp.495-499, 2013] consiste à déposer une nappe de 18 à 36 fils de 200 $\mu$m ou 300 $\mu$m de diamètre directement sur les doigts de collecte. Autrement dit, les cellules photovoltaïques sont dépourvues de busbars. Les fils sont tenus par un film support en polytéréphtalate d'éthylène (PET), qui est collé sur chaque face des cellules. Les fils ont une âme en cuivre et un revêtement extérieur formé d'un alliage à base d'indium. Cet alliage possède une température de fusion inférieure à 150 °C, ce qui permet de réaliser la connexion électrique entre les fils et les doigts de collecte, non pas lors de l'étape d'interconnexion des cellules (par chauffage localisé vers 200 °C), mais lors de l'étape de lamination des modules photovoltaïques (qui se fait à plus basse température, généralement vers 150-160 °C).

Les interconnexions en forme de fil électrique permettent de réduire la longueur des doigts de collecte par rapport à la configuration à trois busbars (Fig.1), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Par contre, elle permet de réduire considérablement la quantité d'argent utilisée pour imprimer les doigts de collecte. En effet, les doigts de collecte étant moins long, on peut soit réduire la largeur des doigts soit utiliser une pâte moins riche en argent (et donc moins conductrice) pour une résistance série équivalente. En outre, grâce à leur section circulaire, les fils électriques ont un ombrage effectif sur la cellule photovoltaïque égal à 70 % seulement de leur diamètre, contre 100 % de la largeur des rubans. Ainsi, pour un ensemble d'interconnexions ayant une même section transversale, le taux d'ombrage sur des cellules interconnectées par fils est plus faible que celui sur des cellules interconnectées par rubans.

Les doigts de collecte sont à l'origine de pertes résistives qui détériorent le facteur de forme (FF, pour « Fill Factor » en anglais) de la cellule photovoltaïque, et donc son rendement. Pour rappel, le facteur de forme FF représente « l'écart » de la caractéristique I-V réelle de la cellule par rapport à une caractéristique idéale rectangulaire. Son expression est la suivante :

[Math 1]

$$FF = \frac{P_{opt}}{I_{CC} \times V_{CO}}$$

où $P_{opt}$ est la puissance fournie par la cellule au point de fonctionnement optimal de la caractéristique I-V réelle, Icc est le courant de court-circuit et Vco est la tension de circuit ouvert. Le rendement $\eta$ de la cellule est lié au facteur de forme FF par la relation suivante :

[Math 2]

$$\eta = \frac{V_{co}.I_{cc}.FF}{P_i}$$

où $P_i$ est la puissance du rayonnement solaire incident.

À ces pertes résistives au niveau de la cellule, il faut ajouter les pertes résistives au niveau du module, i.e. dans les interconnexions. Les pertes résistives dans les interconnexions sont proportionnelles au carré du courant électrique I généré par le module et à la résistance série Rs des interconnexions, qui dépend notamment de la section de cuivre utilisée.

Il existe par ailleurs une technique d'interconnexion de cellules photovoltaïques appelée « shingle » (traduction de « bardeau » ou « tuile » en anglais) qui n'utile pas de rubans ou fils électriques. La technique d'interconnexion « shingle » est par exemple décrite dans l'article [« Materials challenge for shingled cells interconnection », G. Beaucarne, Energy Procedia 98, pp.115-124, 2016].

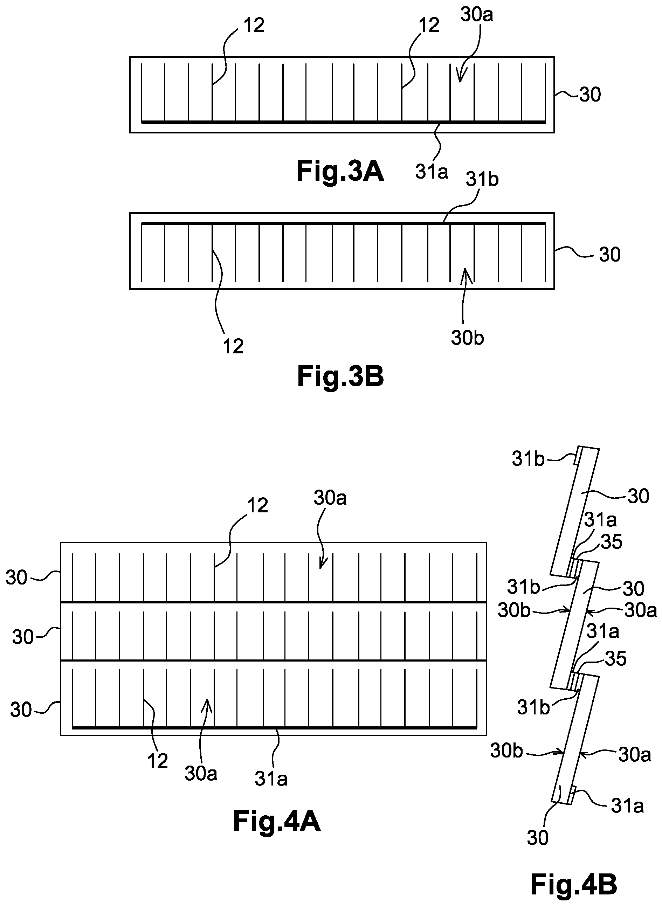

Les figures 3A et 3B montrent respectivement la face 30a et la face arrière 30b d'une cellule photovoltaïque 30 adaptée à la technique d'interconnexion « shingle ». La cellule photovoltaïque 30 est de forme rectangulaire. Sa face avant 30a présente une piste conductrice d'interconnexion ou busbar 31a et une pluralité de doigts de collecte 12 orientés perpendiculairement au busbar 31a. Le busbar 31a s'étend parallèlement au plus grand côté de la cellule photovoltaïque 30 et relie électriquement les doigts de collecte 12. Comme illustré par la figure 1B, la face arrière 30b de la cellule peut présenter une configuration d'électrodes semblable à celle de la face avant 30a (cas des cellules bifaciales), i.e. comprenant un busbar 31b et des doigts de collecte 12, à la différence que le busbar 31b est situé le long du côté opposé de la cellule photovoltaïque 30. Alternativement, la face arrière 30b de la cellule peut être entièrement métallisée (cas des cellules monofaciales) et ne comporter que le busbar 31b.

Les figures 4A et 4B représentent, respectivement en vue de dessus et en coupe transversale, une chaîne de cellules « shingle » 40 fabriquée en interconnectant plusieurs cellules photovoltaïques 30, telles qu'illustrées par les figures 3A et 3B. Les cellules photovoltaïques 30 de la chaîne se chevauchent légèrement, comme des tuiles ou des bardeaux sur un toit. Une portion de la face avant 30a de chaque cellule 30, excepté la dernière cellule de la chaîne, est recouverte par la cellule suivante dans la chaîne. Le busbar 31a de la cellule se situe dans cette portion dite « de recouvrement ». Il est interconnecté avec le busbar 31b situé en face arrière 30b de la cellule 30 suivante, par exemple au moyen d'un adhésif électriquement conducteur 35 (ou ECA, pour « Electrical Conductive Adhesive » en anglais).

Dans la chaîne de cellules « shingle » 40, il n'y a pas d'espace entre les cellules comme dans les chaînes de cellules classiques, formées à l'aide de rubans ou de fils. L'ombrage est en outre minimal, car il n'y a pas d'éléments d'interconnexion en forme de fil ou de ruban rapportés sur la face avant 30a des cellules et le busbar 31a en face avant est recouvert par une surface active d'une autre cellule. Un module ou panneau photovoltaïque construit à partir de telles chaînes aura donc un rapport surface active sur surface totale maximal, permettant d'obtenir un rendement panneau très élevé. US 2017/194516 A1 décrit une cellule photovoltaïque adaptée à la technique d'interconnexion << shingle >> et la chaîne de cellules correspondante, telle que connue dans l'état de l'art.

La technique d'interconnexion « shingle » souffre cependant d'un inconvénient majeur : celui du coût de fabrication d'une chaîne de cellules photovoltaïques. En effet, dans la chaîne de cellules « shingle » 40, le courant électrique produit par les cellules parcourt toute la longueur des doigts de collecte 12. Pour limiter les pertes résistives dans les doigts de collecte 12, ceux-ci sont donc plus larges et plus épais que dans les chaînes de cellules classiques. La quantité d'argent utilisée pour former les doigts de collecte 12 est alors très importante, ce qui augmente significativement le coût de fabrication d'une cellule et donc de la chaîne de cellules. Cet inconvénient du coût est particulièrement critique dans le cas des cellules à hétérojonction qui sont métallisées avec des pâtes d'argent plus résistive que celles utilisées pour les cellules à homojonction (car devant être cuites à basse température, vers 200 °C). Un autre inconvénient d'utiliser des doigts de collecte larges est la diminution de courant produit par chaque cellule, les doigts de collecte larges causant un ombrage plus important.

## RÉSUMÉ DE L'INVENTION

Il existe donc un besoin de fabriquer à moindre coût une chaîne de cellules photovoltaïques « shingle » sans diminuer les performances électriques de la chaîne. L'objet de l'invention est défini par les revendications indépendantes 1, 13 et 14.

Selon un premier aspect de l'invention, on tend à satisfaire ce besoin en prévoyant une cellule photovoltaïque comprenant une face avant destinée à être exposée à un rayonnement incident et une face arrière opposée à la face avant, la face avant présentant :

- une pluralité d'électrodes parallèles entre elles et appelées « doigts de collecte » ;
- une piste conductrice d'interconnexion de largeur supérieure à la largeur des doigts de collecte, s'étendant parallèlement à un bord de la cellule photovoltaïque à moins de 2 mm dudit bord de la cellule photovoltaïque, de préférence à moins de 1 mm dudit bord de la cellule photovoltaïque, les doigts de collecte étant orientés par rapport à la piste conductrice d'interconnexion d'un angle compris entre -65° et 65° ;

et dans laquelle une partie au moins des doigts de collecte sont interconnectés par des éléments de connexion en forme de fils ou de rubans, les éléments de connexion étant disposés sur ladite au moins une partie des doigts de collecte de la face avant.

En orientant les doigts de collecte par rapport à la piste conductrice d'interconnexion d'un angle compris entre -65° et 65°, il est possible d'interconnecter tout ou partie des doigts de collecte entre eux au moyen d'éléments de connexion rapportés sur la face avant de la cellule. Le courant électrique est alors en partie acheminé par les éléments de connexion, par exemple en forme de rubans ou de fils, et non plus exclusivement par les doigts de collecte. La quantité d'argent utilisée pour former les doigts de collecte peut alors être diminuée sans que cela n'ait un impact significatif sur la résistance série de la cellule.

La cellule photovoltaïque selon le premier aspect de l'invention permet ainsi d'obtenir à moindre coût une chaîne de cellules « shingle » ayant des performances élevées, notamment en termes de courant généré. Une chaîne de cellules « shingle » désigne une chaîne de cellules photovoltaïques (obtenue par la technique d'interconnexion « shingle ») dans laquelle les cellules photovoltaïques se chevauchent, face avant contre face arrière, pour être interconnectées en série (les cellules photovoltaïques de la chaîne sont agencées comme les tuiles d'un toit).

La cellule photovoltaïque selon le premier aspect de l'invention peut également présenter une ou plusieurs des caractéristiques ci-dessous, considérées individuellement ou selon toutes les combinaisons techniquement possibles.

La largeur de la piste conductrice d'interconnexion est avantageusement comprise entre 70 μm et 700 μm.

De préférence, les faces avant et arrière sont de forme rectangulaire et présentent un rapport longueur sur largeur compris entre 2 et 10, de préférence égal à un nombre entier naturel compris entre 2 et 10.

Les éléments de connexion sont de préférence orientés perpendiculairement à la piste conductrice d'interconnexion.

Les doigts de collecte sont de préférence orientés parallèlement à la piste conductrice d'interconnexion.

De préférence, au moins un des doigts de collecte interconnectés est relié électriquement à la piste conductrice d'interconnexion.

Dans un mode de réalisation, la cellule photovoltaïque comprend en outre des conducteurs de liaison reliant électriquement ledit au moins un des doigts de collecte interconnectés à la piste conductrice d'interconnexion.

Dans un mode de réalisation, la cellule photovoltaïque comprend en outre des premiers conducteurs de liaison reliant électriquement la piste conductrice d'interconnexion au doigt de collecte le plus proche de la piste conductrice d'interconnexion.

Dans un mode de réalisation, la cellule photovoltaïque comprend en outre des deuxièmes conducteurs de liaison reliant électriquement entre eux les deux doigts de collecte les plus éloignés de la piste conductrice d'interconnexion.

Dans un mode de réalisation, la cellule photovoltaïque comprend en outre des troisièmes conducteurs de liaison reliant électriquement entre eux les deux doigts de collecte les plus proches de la piste conductrice d'interconnexion.

Dans un mode de réalisation, la cellule photovoltaïque comprend en outre une pluralité de premiers plots de soudure alignés sur les doigts de collecte et formant, perpendiculairement aux doigts de collecte, une pluralité de pistes de connexion discontinues.

Selon un développement de ce mode de réalisation, les éléments de connexion sont fixés aux doigts de collecte par l'intermédiaire des pistes de connexion discontinues.

Selon un autre développement, la cellule photovoltaïque comprend en outre une pluralité de deuxièmes plots de soudure alignés sur la piste conductrice d'interconnexion, dans le prolongement des pistes de connexion discontinues, les éléments de connexion étant en outre fixés à la piste conductrice d'interconnexion par l'intermédiaire des deuxièmes plots de soudure.

Dans un mode de réalisation, la face arrière de la cellule photovoltaïque présente :

- une pluralité d'électrodes parallèles entre elles et appelées « doigts de collecte » ;
- une piste conductrice d'interconnexion de largeur supérieure à la largeur des doigts de collecte de la face arrière, s'étendant parallèlement à un bord de la cellule photovoltaïque à moins de 2 mm dudit bord de la cellule photovoltaïque, les doigts de collecte de la face arrière étant orientés par rapport à la piste conductrice d'interconnexion de la face arrière d'un angle compris entre -65° et 65° ;

et dans laquelle une partie au moins des doigts de collecte de la face arrière sont interconnectés par des éléments de connexion additionnels en forme de fils ou de rubans disposés sur la face arrière.

Un deuxième aspect de l'invention concerne une chaîne photovoltaïque comprenant des première et deuxième cellules photovoltaïques selon le premier aspect de l'invention, la deuxième cellule photovoltaïque étant interconnectée avec la première cellule photovoltaïque en recouvrant avec la face arrière de la deuxième cellule photovoltaïque une portion de la face avant de la première cellule dans laquelle se situe la piste conductrice d'interconnexion.

La chaîne photovoltaïque selon le deuxième aspect de l'invention peut également présenter une ou plusieurs des caractéristiques ci-dessous, considérées individuellement ou selon toutes les combinaisons techniquement possibles.

Selon un développement de ce mode de réalisation, les éléments de connexion sont des fils électriques et les fils électriques sont solidaires d'un film support disposé contre les faces avant des première et deuxième cellules photovoltaïques.

Dans une variante de réalisation, les éléments de connexion s'étendent jusqu'à la piste conductrice d'interconnexion.

Un troisième aspect de l'invention concerne un procédé de fabrication d'une cellule photovoltaïque. Ce procédé comprend les étapes suivantes :

- former sur une face d'un substrat d'une pluralité d'électrodes parallèles entre elles, appelées « doigts de collecte », et d'une piste conductrice d'interconnexion de largeur supérieure à la largeur des doigts de collecte, la piste conductrice d'interconnexion s'étendant parallèlement à un bord du substrat à moins de 2 mm dudit bord du substrat, de préférence à moins de 1 mm dudit bord du substrat, et les doigts de collecte étant orientés par rapport à la piste conductrice d'interconnexion d'un angle compris entre - 65° et 65° ;
- interconnecter une partie au moins des doigts de collecte par des éléments de connexion en forme de fils ou de rubans, les éléments de connexion étant déposés sur ladite au moins une partie des doigts de collecte.

Les doigts de collecte et la piste conductrice d'interconnexion sont de préférence formés par sérigraphie, par exemple d'une pâte contenant de l'argent.

Un quatrième aspect de l'invention concerne un procédé de fabrication d'une chaîne photovoltaïque. Ce procédé comprend les étapes suivantes :

- fournir des première et deuxième cellules photovoltaïques comprenant chacune une face avant destinée à être exposée à un rayonnement incident et une face arrière opposée à la face avant, la face avant présentant :

  - une pluralité d'électrodes parallèles entre elles et appelées « doigts de collecte » ;
  - une piste conductrice d'interconnexion de largeur supérieure à la largeur des doigts de collecte, s'étendant parallèlement à un bord de la cellule photovoltaïque à moins de 2 mm dudit bord de la cellule photovoltaïque, les doigts de collecte étant orientés par rapport à la piste conductrice d'interconnexion d'un angle compris entre -65° et 65° ;

- interconnecter dans chacune des première et deuxième cellules photovoltaïques une partie au moins des doigts de collecte par des éléments de connexion en forme de fils ou de rubans, les éléments de connexion étant déposés sur ladite au moins une partie des doigts de collecte de la face avant ;
- interconnecter la deuxième cellule photovoltaïque avec la première cellule photovoltaïque en recouvrant une portion de la face avant de la première cellule photovoltaïque dans laquelle se situe la piste conductrice d'interconnexion.

Le procédé de fabrication de chaîne photovoltaïque selon le quatrième aspect de l'invention peut également présenter une ou plusieurs des caractéristiques ci-dessous, considérées individuellement ou selon toutes les combinaisons techniquement possibles.

Dans un mode de mise en œuvre, les éléments de connexion sont déposés sur la face avant des première et deuxième cellules photovoltaïques après l'étape d'interconnexion des première et deuxième cellules photovoltaïques.

Selon un développement de ce mode de mise en œuvre, le procédé comprend les opérations suivantes :

- fournir des fils électriques solidaires d'un film support ;
- découper les fils électriques en segments de fils électriques de longueur inférieure à la largeur des première et deuxième cellules photovoltaïques ; et

- plaquer le film support contre la face avant des première et deuxième cellules photovoltaïques de façon à mettre en contact les fils électriques avec les doigts de collecte.

Les fils électriques peuvent être découpés avant, pendant ou après l'étape de plaquage du film support contre la face avant des première et deuxième cellules photovoltaïques.

Dans une variante de mise en œuvre, les éléments de connexion sont déposés sur la face avant des première et deuxième cellules photovoltaïques avant l'étape d'interconnexion des première et deuxième cellules photovoltaïques.

Les éléments de connexion peuvent s'étendre jusqu'à la piste conductrice d'interconnexion.

De préférence, les première et deuxième cellules photovoltaïques sont interconnectées par soudage ou collage au moyen d'un adhésif électriquement conducteur.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.

[Fig. 1] représente schématiquement une technique d'interconnexion de cellules photovoltaïques selon l'art antérieur.

[Fig. 2] représente schématiquement une autre technique d'interconnexion de cellules photovoltaïques selon l'art antérieur.

[Fig. 3A] montre la face avant d'une cellule photovoltaïque selon l'art antérieur, adaptée à la technique d'interconnexion « shingle ».

[Fig. 3B] montre la face arrière d'une cellule photovoltaïque selon l'art antérieur, adaptée à la technique d'interconnexion « shingle ».

[Fig. 4A] représente schématiquement et en vue de dessus une chaîne de cellules selon l'art antérieur, obtenue grâce à la technique d'interconnexion « shingle ».

[Fig. 4B] représente schématiquement et en coupe transversale la chaîne de cellules de la figure 4A.

[Fig. 5] représente un premier mode de réalisation d'une cellule photovoltaïque selon le premier aspect de l'invention.

[Fig. 6] représente un deuxième mode de réalisation d'une cellule photovoltaïque selon le premier aspect de l'invention.

[Fig. 7] représente un troisième mode de réalisation d'une cellule photovoltaïque selon le premier aspect de l'invention.

[Fig. 8] représente un quatrième mode de réalisation d'une cellule photovoltaïque selon le premier aspect de l'invention.

[Fig. 9] représente un cinquième mode de réalisation d'une cellule photovoltaïque selon le premier aspect de l'invention.

[Fig. 10] représente un sixième mode de réalisation d'une cellule photovoltaïque selon le premier aspect de l'invention.

[Fig. 11] représente un septième mode de réalisation d'une cellule photovoltaïque selon le premier aspect de l'invention.

[Fig. 12A] représente une étape d'un premier procédé pour fabriquer une chaîne photovoltaïque selon le deuxième aspect de l'invention, avec pour exemple des cellules photovoltaïques selon la figure 6.

[Fig. 12B] représente une autre étape du premier procédé de fabrication.

[Fig. 12C] représente une autre étape du premier procédé de fabrication.

[Fig. 13] montre une chaîne photovoltaïque comprenant plusieurs cellules photovoltaïques selon la figure 7, obtenue à l'issue du premier procédé de fabrication.

[Fig. 14] montre une chaîne photovoltaïque comprenant plusieurs cellules photovoltaïques selon la figure 8, obtenue à l'issue du premier procédé de fabrication.

[Fig. 15A] représente une étape d'un deuxième procédé pour fabriquer une chaîne photovoltaïque selon le deuxième aspect de l'invention, avec pour exemple des cellules photovoltaïques selon la figure 6.

[Fig. 15B] montre une autre étape du deuxième procédé de fabrication.

[Fig. 15C] montre une autre étape du deuxième procédé de fabrication.

[Fig. 16A] représente une étape d'un troisième procédé pour fabriquer une chaîne photovoltaïque selon le deuxième aspect de l'invention, avec pour exemple des cellules photovoltaïques selon la figure 6.

[Fig. 16B] montre une autre étape du troisième procédé de fabrication.

[Fig. 16C] montre une autre étape du troisième procédé de fabrication.

[Fig. 17A] représente une étape d'un quatrième procédé pour fabriquer une chaîne photovoltaïque selon le deuxième aspect de l'invention, avec pour exemple des cellules photovoltaïques selon la figure 5.

[Fig. 17B] montre une autre étape du quatrième procédé de fabrication.

[Fig. 17C] montre une autre étape du quatrième procédé de fabrication.

[Fig. 18] représente une variante de mise en œuvre de l'étape selon la figure 16B.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

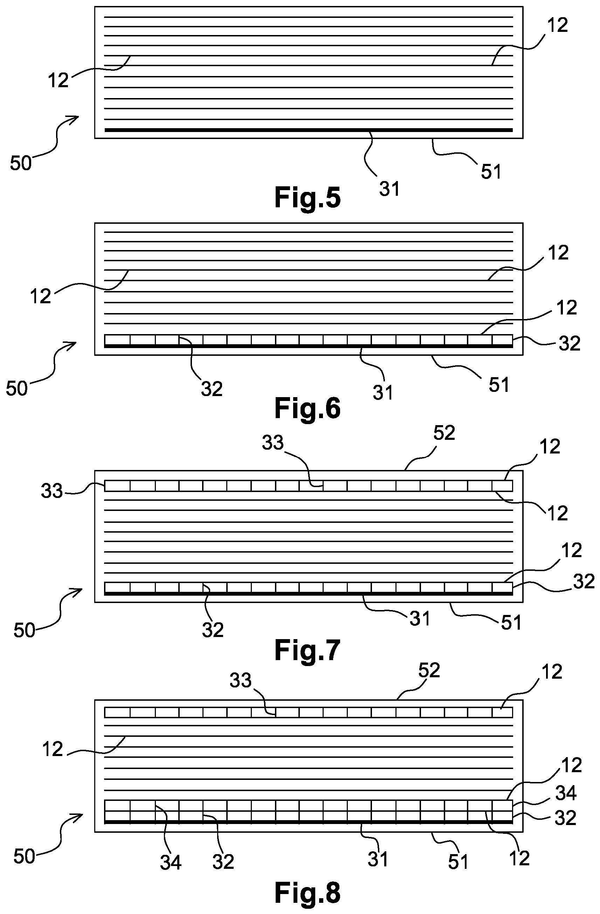

Les figures 5 à 11 illustrent différents modes de réalisation d'une cellule photovoltaïque 50 selon un aspect de l'invention. La cellule photovoltaïque 50 est conçue de façon à pouvoir fabriquer à moindre coût des chaînes de cellules « shingle ». La cellule photovoltaïque 50 a été fabriquée à partir d'un substrat en matériau semi-conducteur, par exemple en silicium. Il peut notamment s'agir d'une cellule à homojonction (HMJ) de silicium ou d'une cellule à hétérojonction de silicium (SHJ).

La cellule photovoltaïque 50 comprend une face avant destinée à être exposée à un rayonnement électromagnétique incident, typiquement le rayonnement solaire, et une face arrière opposée à la face avant. La cellule photovoltaïque 50 peut être une cellule monofaciale ou bifaciale. Dans une cellule monofaciale, seule la face avant capte le rayonnement solaire. Dans une cellule bifaciale, les faces avant et arrière captent chacune une partie du rayonnement solaire. La face avant capte le rayonnement incident (i.e. direct) tandis que la face arrière capte le rayonnement diffus ou réfléchi. La face avant d'une cellule bifaciale est celle permettant d'obtenir le maximum de courant électrique lorsqu'elle est tournée vers le rayonnement incident. Les figures 5 à 11 montrent la face avant de la cellule photovoltaïque 50.

Les faces avant et arrière (aussi appelées faces principales) de la cellule photovoltaïque 50 sont avantageusement parallèles entre elles et de même superficie. Elles ont de préférence une forme rectangulaire. Par exemple, le grand côté de la cellule photovoltaïque 50 mesure 156 mm alors que le petit côté mesure 31,2 mm ou 26 mm. La cellule photovoltaïque 50 est de préférence obtenue par découpage d'une cellule photovoltaïque de pleine taille, présentant un format standard (par exemple 156 mm x 156 mm). La cellule photovoltaïque 50 constitue alors un morceau de la cellule photovoltaïque de pleine taille appelé « tuile ».

La cellule photovoltaïque de pleine taille est avantageusement découpée en plusieurs tuiles 50 de même superficie. Ainsi, les tuiles produiront sensiblement le même courant électrique et une chaîne formée de ces tuiles ne verra pas son courant limité par une tuile plus petite. À titre d'exemple, chaque tuile 50 représente un cinquième ou un sixième de la cellule photovoltaïque de pleine taille.

De manière plus générale, les faces avant et arrière de la cellule photovoltaïque 50 peuvent présenter un rapport longueur (grand côté du rectangle) sur largeur (petit côté du rectangle) compris entre 2 et 10, de préférence entre 4 et 6. Ce rapport longueur sur largeur est avantageusement égal à un nombre entier naturel compris entre 2 et 10, de préférence entre 4 et 6.

Le découpage des tuiles 50 peut être réalisé de différentes manières, par exemple par sciage, en formant un sillon avec un laser puis en clivant la cellule, ou par une technique laser appelée TLS (pour « Thermal Laser Separation » en anglais) qui repose sur une séparation thermique initiée par un laser.

D'une manière commune à tous les modes de réalisation, la face avant de la cellule photovoltaïque 50 présente une pluralité de doigts de collecte 12 et au moins une piste conductrice d'interconnexion 31. Les doigts de collecte 12 et la piste conductrice d'interconnexion 31 sont des métallisations. Ces métallisations sont avantageusement formées en une seule et même étape, par exemple par sérigraphie d'une pâte contenant de l'argent.

Les doigts de collecte 12 sont des électrodes de forme allongée et parallèles entre elles, destinées à collecter les porteurs de charge photogénérés au sein de la cellule tout en laissant la quasi-totalité du rayonnement incident atteindre le substrat. Ils sont de préférence répartis sur la toute la superficie de la face avant. Leur largeur est inférieure à 100 μm, de préférence inférieure à 60 μm.

La piste conductrice d'interconnexion 31, de largeur supérieure à la largeur des doigts de collecte 12, sert à interconnecter la cellule photovoltaïque 50 à une autre cellule photovoltaïque du même type, pour former une chaîne (ou guirlande) photovoltaïque. La piste conductrice d'interconnexion 31 s'étend parallèlement à un premier bord 51 de la cellule photovoltaïque 50, de préférence le grand côté de la cellule. La distance qui sépare la piste conductrice d'interconnexion 31 et le premier bord 51 est inférieure à 2 mm, de préférence inférieure à 1 mm. La longueur de la piste conductrice d'interconnexion 31 (mesurée parallèlement au premier bord 51) est de préférence supérieure à 99 % de longueur du premier bord 51.

La largeur de la piste conductrice d'interconnexion 31 (mesurée perpendiculairement au premier bord 51) est avantageusement comprise entre 70 μm et 700 μm. Des liaisons électrique et mécanique performantes peuvent ainsi être obtenues entre deux cellules photovoltaïques 50 d'une même chaîne.

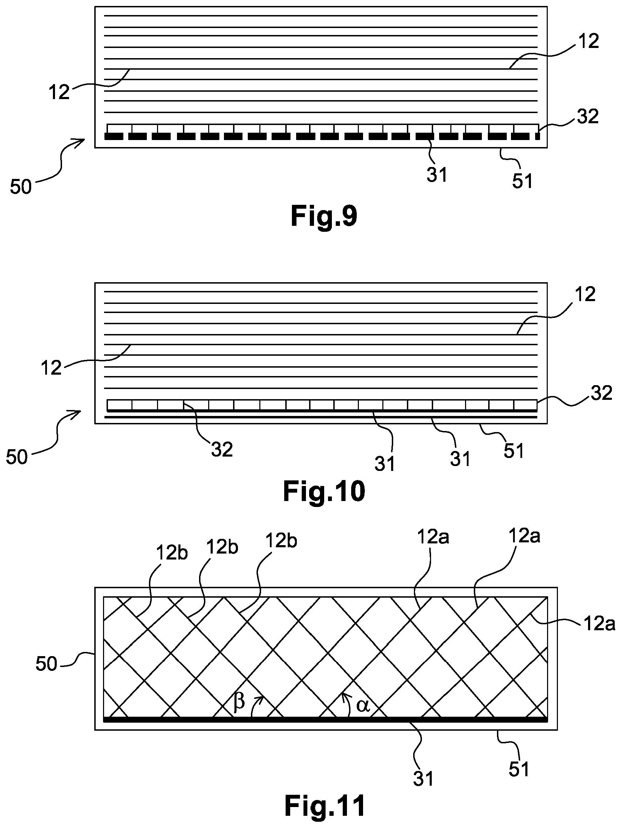

La piste conductrice d'interconnexion 31 peut être continue, tel qu'illustré par les figures 5-8 et 11, ou discontinue comme sur la figure 9. La face avant de la cellule photovoltaïque 50 peut aussi comporter plus d'une piste conductrice d'interconnexion 31. Ainsi, dans le mode de réalisation de la figure 10, la face avant de la cellule photovoltaïque comporte deux pistes conductrices d'interconnexion 31 parallèles.

Les doigts de collecte 12 de la cellule photovoltaïque 50 sont orientés par rapport à la piste conductrice d'interconnexion 31 d'un angle compris entre -65° et 65°. On considère ici le plus petit angle entre la piste conductrice d'interconnexion 31 et les doigts de collecte 12. Cet angle est compris entre 0 et 65° en valeur absolue. Dans les modes de réalisation illustrés par les figures 5 à 10, les doigts de collecte 12 sont orientés parallèlement à la piste conductrice d'interconnexion 31. Autrement dit l'angle entre les doigts de collecte 12 et la piste conductrice d'interconnexion 31 est nul. Dans le mode de réalisation de la figure 11, la face avant présente une pluralité de premiers doigts de collecte 12a orientés d'un angle α positif inférieur à 65° par rapport à la piste conductrice d'interconnexion 31 et une pluralité de deuxièmes doigts de collecte 12b orientés d'un angle β négatif supérieur à -65° par rapport à la piste conductrice d'interconnexion 31. Par exemple, les premiers doigts de collecte 12a sont orientés d'un angle α égal à 45° et les deuxièmes doigts de collecte 12b sont orientés d'un angle β égal à -45°.

Ainsi, à la différence des busbars employés dans les cellules photovoltaïques de l'art antérieur, la piste conductrice d'interconnexion 31 ne relie pas nécessairement entre eux les doigts de collecte 12.

Dans le mode de réalisation de la figure 6, la face avant de la cellule photovoltaïque 50 comporte, en plus des doigts de collecte 12 et de la piste conductrice d'interconnexion 31, une pluralité de premiers conducteurs de liaison 32. Les premiers conducteurs de liaison 32 relient électriquement la piste conductrice d'interconnexion 31 au doigt de collecte 12 le plus proche de la piste conductrice d'interconnexion 31.

Le mode de réalisation de la figure 7 diffère de celui de la figure 6 en ce que la face avant de la cellule photovoltaïque 50 comporte en outre une pluralité de deuxièmes conducteurs de liaison 33 reliant électriquement entre eux les deux doigts de collecte 12 les plus éloignés de la piste conductrice d'interconnexion 31. Par conséquent, les deuxièmes conducteurs de liaison 33 sont proches d'un deuxième bord 52 de la cellule photovoltaïque 50 situé à l'opposé du premier bord 51.

Dans le mode de réalisation de la figure 8, la face avant de la cellule photovoltaïque 50 comporte en outre une pluralité de troisièmes conducteurs de liaison 34 reliant électriquement entre eux les deux doigts de collecte 12 les plus proches de la piste conductrice d'interconnexion 31. Les troisièmes conducteurs de liaison 34 peuvent venir en complément des premiers et deuxièmes conducteurs de liaison 32-33 (cf. Fig.8) ou en complément des premiers conducteurs de liaison 32 uniquement.

Les premiers, deuxièmes et troisièmes conducteurs de liaison 32, 33, 34 peuvent être orientés perpendiculairement à la piste conductrice d'interconnexion 31 et aux doigts de collecte 12. Ils pourront donc également être qualifiés de premiers, deuxièmes et troisièmes conducteurs transversaux. Ils sont avantageusement formés en même temps que les doigts de collecte 12 et de la piste conductrice d'interconnexion 31. Leur largeur est par exemple égale à celle des doigts de collecte 12 ou comprise entre 1 et 3 fois la largeur des doigts de collecte 12.

Dans un mode de réalisation, les premiers, deuxièmes et troisièmes conducteurs de liaison 32, 33, 34 sont inclinés par rapport à la piste conductrice d'interconnexion 31 et aux doigts de collecte 12 d'un angle compris en valeur absolue entre 40° et 70° (par exemple 60°) ou entre 110° et 150° (par exemple 120°). Une telle inclinaison est préférable lorsque des écrans de sérigraphie dits « 0° » ou « knotless » sont utilisés pour faciliter l'impression des doigts de collecte (car ces écrans ne permettent pas d'imprimer correctement des conducteurs étroits orientés perpendiculairement aux doigts de collecte).

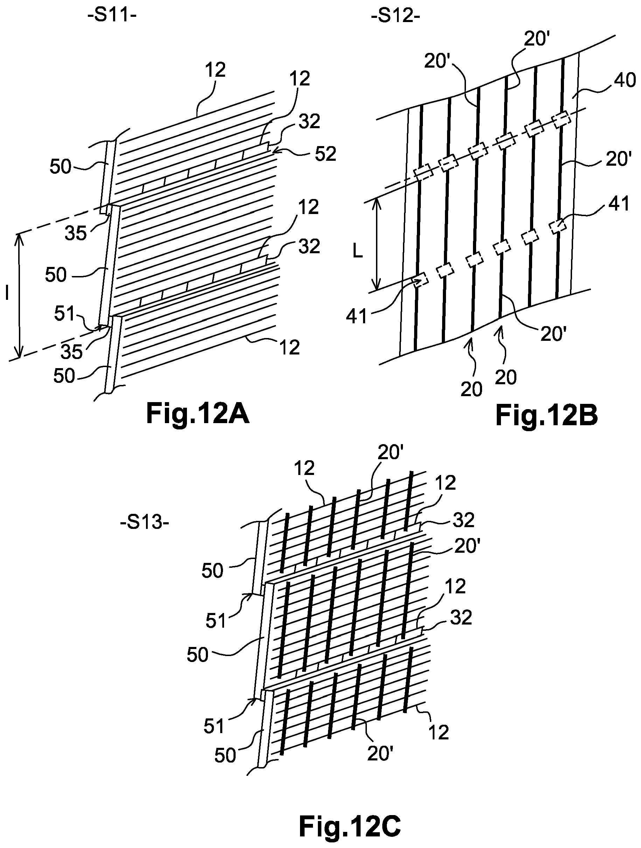

L'utilité des premiers, deuxièmes et troisièmes conducteurs de liaison 32, 33, 34 sera décrite ci-après en relation avec les figures 12 à 14.

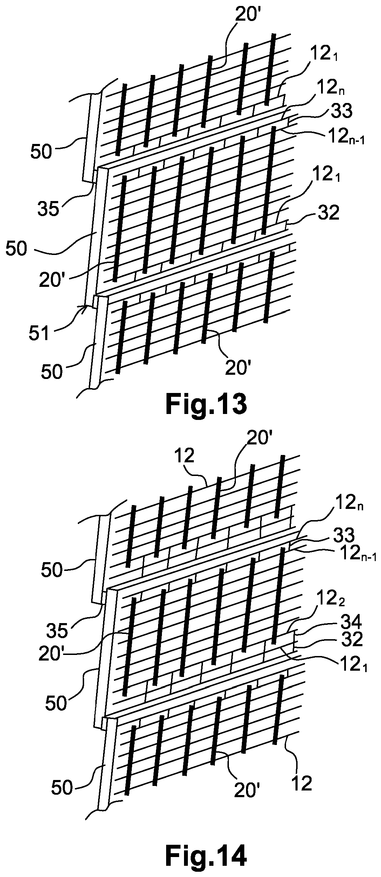

La cellule photovoltaïque 50 peut également comporter des éléments de connexion 20, 20' ou 22 disposés sur la face avant de la cellule photovoltaïque, comme illustré sur les figures 12C, 13, 14, 15C, 16B, 17B et 18. Les éléments de connexion 20, 20', 22, par exemple en forme de fils ou de rubans électriques, interconnectent une partie au moins des doigts de collecte 12 de la cellule photovoltaïque 50. Sur les figures 13 et 14, les éléments de connexion 20' interconnectent une partie seulement des doigts de collecte 12. Sur les figures 12C, 15C, 16B, 17B et 18, les éléments de connexion 20, 20', 22 interconnectent tous les doigts de collecte 12.

Au moins un des doigts de collecte 12 interconnectés par les éléments de connexion 20, 20', 22 est relié électriquement à la piste conductrice d'interconnexion 31. Ledit au moins un doigt de collecte peut être relié à la piste conductrice d'interconnexion 31 :

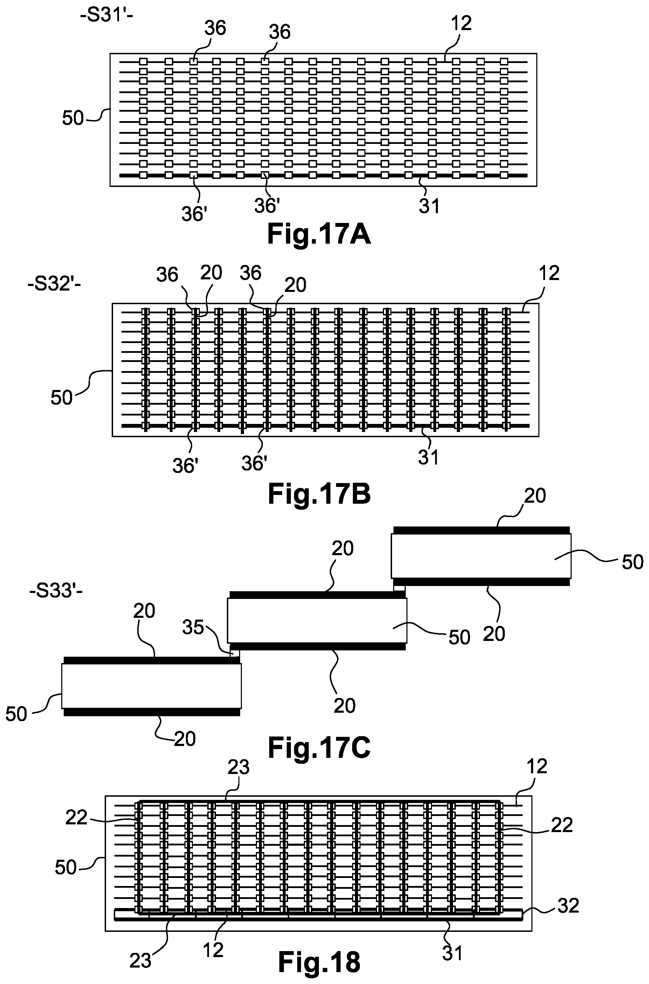

- directement (cas d'un angle suffisamment grand pour que le doigts de collecte intersecte la piste conductrice d'interconnexion 31 ; cf. Fig.11) ; ou
- par l'intermédiaire des conducteurs de liaison 32, 34 (lorsque l'angle est suffisamment faible pour qu'aucun des doigts de collecte 12 n'intersecte la piste conductrice d'interconnexion 31) ; ou
- par l'intermédiaire des éléments de connexion 20 en forme de fils ou de rubans, lorsque ceux-ci s'étendent jusqu'à la piste conductrice d'interconnexion 31 (cf. Figs.17B-17C).

La face arrière de la cellule photovoltaïque 50 peut présenter une configuration semblable à celle de la face avant, c'est-à-dire des doigts de collecte, au moins une piste conductrice d'interconnexion et des éléments de connexion additionnels (en forme de fils ou de rubans) interconnectant une partie au moins des doigts de collecte de la face arrière (cas d'une cellule bifaciale). La face arrière peut alternativement présenter une configuration classique d'électrodes (cas d'une cellule bifaciale), par exemple en sérigraphiant la face arrière avec une quantité élevée d'argent, ou être entièrement métallisée et ne comporter qu'une (ou plusieurs) piste(s) conductrice(s) d'interconnexion (cas d'une cellule monofaciale). En face arrière, la piste conductrice d'interconnexion s'étend le long du deuxième bord 52 de la cellule photovoltaïque 50. Ainsi, l'agencement des métallisations et des éléments de connexion décrit précédemment peut ne concerner que la face avant de la cellule photovoltaïque 50, quel que soit le type de cellule photovoltaïque, bifaciale ou monofaciale.

Un autre aspect de l'invention, relatif à un procédé de fabrication d'une chaîne photovoltaïque (ou procédé d'interconnexion de cellules photovoltaïques) va maintenant être décrit en référence aux figures 12 à 18. La chaîne photovoltaïque comporte au moins deux cellules photovoltaïques 50 connectées électriquement en série. Naturellement, le nombre de cellules photovoltaïques 50 dans la chaîne photovoltaïque peut être supérieur à 2. Il est typiquement compris entre 50 et 80 (selon le format des cellules/tuiles et celui du module).

Les figures 12A-12C illustrent un premier mode de mise en œuvre du procédé de fabrication de chaîne photovoltaïque. Les différentes étapes du procédé seront décrites en détail à l'aide de ces figures en prenant comme exemple les cellules photovoltaïques 50 de la figure 6. Pour ne pas alourdir inutilement les figures 12A et 12C, seules trois cellules photovoltaïques 50 ont été représentées.

En référence à la figure 12A, le procédé comprend une étape S11 consistant à connecter, mécaniquement et électriquement, les cellules photovoltaïques 50 les unes aux autres en les faisant se chevaucher, face avant contre face arrière. Une chaîne de cellules « shingle » est ainsi formée. Une portion de la face avant de chaque cellule, excepté la dernière cellule de la chaîne, est recouverte par la cellule suivante dans la chaîne. La piste conductrice d'interconnexion 31 de la cellule se situe dans cette portion appelée « zone de recouvrement ». Elle est interconnectée avec la piste conductrice d'interconnexion située en face arrière de la cellule suivante, par exemple au moyen d'un adhésif électriquement conducteur 35 (ou ECA, pour « Electrical Conductive Adhesive » en anglais). Une technique de soudage peut être alternativement utilisée pour interconnecter les pistes conductrices d'interconnexion 31. L'utilisation d'un adhésif électriquement conducteur 35 peut permettre d'obtenir une interconnexion plus fiable, car l'adhésif est plus ductile qu'une soudure.

Les cellules photovoltaïques 50 de la chaîne sont de préférence alignées dans une direction perpendiculaire aux premiers bords 51 des cellules photovoltaïques 50. La zone de recouvrement est alors une bande de largeur constante qui s'étend sur toute la longueur du premier bord 51.

A ce stade, la collecte des porteurs de charge photogénérés est très peu efficace car, en face avant de chaque cellule, tous les doigts de collecte 12 ne sont pas reliés à la piste conductrice d'interconnexion 31 (et donc aux autres cellules de la chaîne). Les performances de la chaîne de cellules « shingle », en termes de courant et de rendement notamment, sont donc très faibles. Les autres étapes du procédé visent à interconnecter tous les doigts de collecte 12 à la piste conductrice d'interconnexion 31. Pour ce faire, des éléments de connexion vont être utilisés.

La figure 12B représente l'étape S12 de préparation de ces éléments de connexion, avant leur report sur la face avant des cellules photovoltaïques 50.

Dans ce premier mode de mise en œuvre, les éléments de connexion sont formés de fils électriques 20 solidaires d'un film support 40, à la manière d'une nappe de fils et conformément à la technologie « SmartWire ». Le film support 40 présente un caractère adhésif lorsqu'il est chauffé à une température comprise entre 100°C et 120°C. Ce caractère adhésif permet le maintien des fils électriques 20 sur le film support 40 et le collage du film support sur les cellules photovoltaïques 50. Le film support 40 est par exemple formé de deux couches superposées, une couche de polytéréphtalate d'éthylène (PET) et une couche de polyéthylène basse densité (PE-LD), ou d'une seule couche de polyoléfine. Le film support en polyoléfine présente une meilleure résistance aux rayons ultraviolets (UV) que le film support bicouche PET/PE-LD. Le film support 40 présente des dimensions sensiblement identiques à celles de la chaîne de cellules « shingle », obtenue à l'issue de l'étape S11 (cf. Fig.12A).

Les fils électriques 20 maintenus par le film support 40 sont de préférence parallèles entre eux. Leur nombre est par exemple compris entre 10 et 36 (pour des cellules photovoltaïques 50 de longueur comprise entre 156 mm et 162 mm) et leur diamètre est avantageusement compris entre 100 $\mu$m et 200 $\mu$m. Ils comportent une âme métallique, par exemple en cuivre, et un revêtement formé d'un alliage métallique ayant une température de fusion inférieure à 150 °C. L'alliage métallique est par exemple composé d'indium et d'étain (InSn) ou d'étain, de bismuth et d'argent (SnBiAg).

Les fils électriques 20, initialement continus, sont découpés après leur collage sur le film support 40 afin de former des groupes de segments de fils 20'. Le nombre de groupes de segments de fils 20' est identique au nombre de cellules photovoltaïques 50 dans la chaîne et, dans chaque groupe, les segments de fils 20' sont avantageusement alignés. Les segments de fils 20' ont une longueur L légèrement inférieure à la largeur l d'une cellule photovoltaïque 50. Pour réaliser ce découpage, des portions de fil de longueur supérieure ou égale à la largeur des zones de recouvrement sont avantageusement retirées dans des zones 41 dite de découpage. Par exemple, les zones de recouvrement des cellules photovoltaïques 50 présentent une largeur de 1 mm tandis que les portions de fil retirées ont une longueur de 2 mm. Les zones de découpage 41 sont par exemple obtenues par poinçonnage des fils électriques 20 et du film support 40.

La fourniture des fils électriques 20 et du film support 40, puis le découpage des fils électriques 20 en segments de fils 20' étant des opérations indépendantes de la formation de la chaîne de cellules « shingle », l'étape S12 de la figure 12B peut être réalisée avant, après ou en parallèle de l'étape S11 de la figure 12A.

L'étape S13 de la figure 12C consiste à plaquer le film support 40 contre la face avant des cellules photovoltaïques 50 de façon à amener chaque groupe de segments de fils 20' directement en contact avec les doigts de collecte 12 d'une cellule associée. De préférence, la disposition des fils électriques 20 sur le film support 40 est telle que, lorsque le film support 40 est appliqué sur la chaîne de cellules, les segments de fils 20' se retrouvent orientés perpendiculairement aux premiers bords 51 des cellules photovoltaïques 50, autrement dit dans la direction de « chaînage » des cellules photovoltaïques 50. Les segments de fils 20' de chaque groupe ont sur la figure 12C une longueur suffisante pour contacter tous les doigts de collecte 12 de la cellule associée.

Avant de plaquer le film support 40, les zones de découpage 41 sont alignées sur les zones de recouvrement des cellules photovoltaïques 50. Elles viennent ensuite recouvrir une paroi latérale des cellules photovoltaïques 50. Grâce aux zones de découpage 41, les faces avant des cellules photovoltaïques 50 ne sont pas court-circuitées entre elles.

Comme le film support 40 est souple, celui-ci peut être plaqué contre les cellules photovoltaïques 50 par laminage à l'aide d'un rouleau. Le rouleau est avantageusement chauffé à une température comprise entre 100 °C et 120 °C pour améliorer l'adhésion du film support 40 sur les cellules.

À l'issue de l'étape S13, le contact électrique entre les segments de fils 20' et les doigts de collecte 12 n'est pas encore établi. Ce contact électrique s'opère lors d'une étape ultérieure par fusion du revêtement des fils, et de préférence, lors de l'étape de lamination du module photovoltaïque (accomplie à une température de 145 °C-165 °C).

Ce mode de mise en œuvre du procédé de fabrication, lorsqu'il utilise les cellules photovoltaïques 50 de la figure 6, requiert une précision d'alignement élevée pour que les segments de fils 20' viennent contacter le doigt de collecte 12 situé le plus proche de piste conductrice d'interconnexion 31 (et en dehors de la zone de recouvrement). Comme ce doigt de collecte 12 est relié électriquement à la piste conductrice d'interconnexion 31 (située dans la zone de recouvrement) par les premiers conducteurs de liaison 32, une continuité électrique est assurée entre les doigts de collecte 12 interconnectés et la piste conductrice d'interconnexion 31.

Ainsi, grâce aux premiers conducteurs de liaison 32, les fils électriques n'ont pas besoin de s'étendre jusqu'à la zone de recouvrement pour être en contact avec la piste conductrice d'interconnexion 31. L'épaisseur d'adhésif électriquement conducteur 35 requise pour interconnecter les cellules photovoltaïques 50 peut ainsi être minimisée.

Une deuxième nappe de fils, identique à celle décrite en relation avec la figure 12B, peut être prévue et appliquée contre les faces arrière des cellules photovoltaïques 50. Cette deuxième nappe de fil est utile uniquement dans le cas de cellules bifaciales munies de doigts de collecte 12 en face arrière. Dans le cas de cellules monofaciales, la collecte des porteurs de charge en face arrière et leur acheminement vers la piste conductrice d'interconnexion peut être assurée par une couche électriquement conductrice (par exemple en aluminium) recouvrant toute la face arrière.

La figure 13 montre une chaîne photovoltaïque obtenue lorsque le procédé de fabrication selon le premier mode de mise en œuvre (étapes S11-S13, cf. Figs.12A-12B) est accompli avec les cellules photovoltaïques 50 de la figure 7 (plutôt qu'avec celles de la figure 6). Dans ce deuxième cas de figure, la contrainte d'alignement est plus faible car les segments de fils 20' peuvent ne pas contacter le doigt de collecte $12_n$ le plus éloigné de la piste conductrice d'interconnexion 31, qualifié de « dernier » doigt de collecte en partant du premier bord 51. En effet, les deuxièmes conducteurs de liaison 33 assurent la continuité électrique entre ce dernier doigt de collecte $12_n$ et l'avant-dernier doigt de collecte $12_{n-1}$. Autrement dit, l'interconnexion des doigts de collecte 12 par les segments de fils 20' peut commencer au premier doigt de collecte $12_1$ (le plus proche de la piste conductrice d'interconnexion 31 et situé en dehors de la zone de recouvrement) et s'arrêter à l'avant-dernier doigt de collecte $12_{n-1}$.

La figure 14 montre une chaîne photovoltaïque obtenue lorsque le procédé de fabrication selon le premier mode de mise en œuvre est accompli avec les cellules photovoltaïques 50 de la figure 8 (plutôt qu'avec celles de la figure 6 ou de la figure 7). Dans ce troisième cas de figure, la contrainte d'alignement est encore plus faible car le premier doigt de collecte $12_1$, comme le dernier doigt de collecte $12_n$, peut ne pas être interconnecté par les segments de fils 20'. Le premier doigt de collecte $12_1$ est en effet relié électriquement au deuxième doigt de collecte $12_2$ (interconnecté avec les autres grâce aux segments de fils) par les troisièmes conducteurs de liaison 34, tandis que le dernier doigt de collecte $12_n$ est relié électriquement à l'avant-dernier doigt de collecte $12_{n-1}$ par les deuxièmes conducteurs de liaison 33.

Ainsi, les deuxièmes et troisièmes conducteurs de liaison 33-34 facilitent l'étape S13 de report de la nappe de fils électriques sur les cellules photovoltaïques 50.

Le premier mode de mise en œuvre du procédé de fabrication (étapes S11-S13, cf. Figs.12A-12B) est compatible avec d'autres modes de réalisation de la cellule photovoltaïque 50 que ceux des figures 5 à 7, notamment ceux des figures 9 à 11.

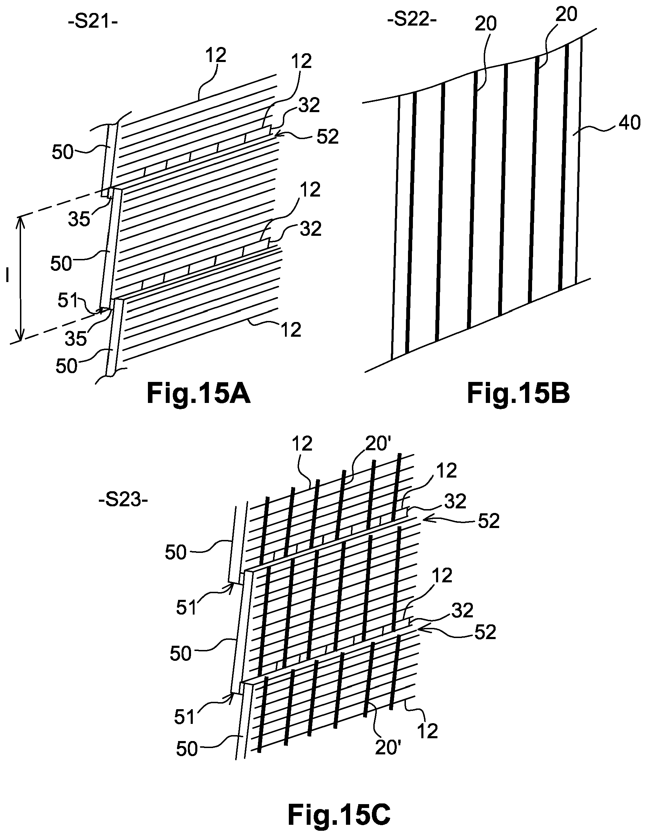

Les figures 15A à 15C illustrent un deuxième mode de mise en œuvre du procédé de fabrication de chaîne photovoltaïque.

En référence à la figure 15A, les cellules photovoltaïque 50 sont agencées en chaîne de cellules « shingle » (i.e. en cascade ou en bardeaux) de la même façon que celle décrite en relation avec la figure 12A.

La figure 15B représente une étape S22 de préparation d'une nappe de fils destinée à être reportée sur la chaîne de cellules photovoltaïques 50. Cette nappe de fils, du même type que celle prévue au départ de l'étape S12, comprend une pluralité de fils électriques 20 continus et un film support 40 sur lequel sont collés les fils électriques 20. Cependant, contrairement au premier mode de mise en œuvre, aucun découpage des fils électriques 20 n'est réalisé à cette étape.

A l'étape S23 de la figure 15C, le film support 40 est ensuite plaqué contre la face avant des cellules photovoltaïques 50 de façon à mettre en contact les fils électriques 20 avec les doigts de collecte 12. Lors de cette même étape, les fils électriques 20 sont pressés contre des arêtes saillantes délimitant le deuxième bord 52 des cellules photovoltaïques 50. Les fils électriques 20 sont alors rompus au niveau de ces arêtes saillantes, obtenant ainsi les différents groupes de segments de fils 20'. De telles arêtes saillantes peuvent être obtenues lors du sciage ou du clivage de la cellule photovoltaïque de pleine taille (le clivage étant avantageusement initié par laser ou la formation d'une rayure).

Le film support 40 peut être plaqué contre les cellules photovoltaïques 50, et les fils électriques 20 découpés, en passant un rouleau sur la chaîne de cellule « shingle ». Le diamètre des fils électriques 20 est avantageusement inférieur ou égal à 150 $\mu$m, de préférence compris entre 50 $\mu$m et 100 $\mu$m, afin qu'ils puissent être découpés facilement sans exercer une trop forte contrainte mécanique sur la chaîne de cellules « shingle ».

Le découpage des fils électriques 20 peut également être accompli après le plaquage du film support 40 sur la face avant des cellules photovoltaïques 50.

Ainsi, dans ce deuxième mode de mise en œuvre, les fils électriques 20 solidaires du film support 40 (type « SmartWire ») sont découpés en segments de fils 20' pendant ou après leur report sur la face avant des cellules photovoltaïques 50, alors que dans le premier mode de mise en œuvre, ils sont découpés en segments de fils 20' avant le report (cf. étape S12 de la figure 12B).

A l'instar du premier mode de mise en œuvre, le deuxième mode de mise en œuvre est compatible avec tous les modes de réalisation de la cellule photovoltaïque 50, à l'exception de celui de la figure 5.

Le procédé de fabrication selon le deuxième mode de mise en œuvre s'affranchit de la contrainte d'alignement des zones de découpage sur les zones de recouvrement et d'une opération de découpage à part entière. Il est donc plus rapide et plus simple à mettre en œuvre.

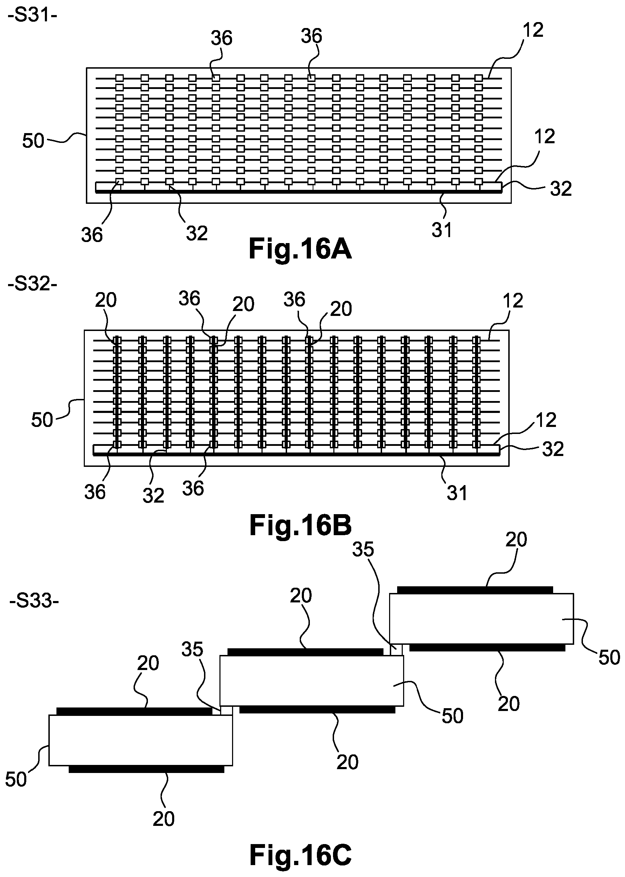

Les figures 16A à 16C illustrent un troisième mode de mise en œuvre du procédé de fabrication de chaîne photovoltaïque. Ce troisième mode de mise en œuvre diffère des premier et deuxième modes de mise en œuvre en ce qu'une partie au moins des doigts de collecte 12 sont interconnectés par des fils électriques avant que les cellules 50 ne soient interconnectées en « shingle ». Il sera décrit en détail en prenant comme exemple des cellules photovoltaïque du type représenté à la figure 6.

La figure 16A représente une étape S31 de dépôt d'une pâte à souder (ou à braser) sur les doigts de collecte 12 de chaque cellule photovoltaïque 50 à interconnecter. La pâte à souder est déposée, par exemple par sérigraphie, de façon à former une pluralité de plots de soudure 36 alignés sur les doigts de collecte 12. Ces plots de soudure 36 sont destinés à recevoir les fils électriques. Ils forment, perpendiculairement aux doigts de collecte 12, une pluralité de pistes de connexion discontinues (de façon similaire aux « busbars » discontinus formés de plots de métallisation). La pâte à souder est par exemple composée de billes en alliage SnPb/SnPbAg (température de fusion supérieure à 170 °C) ou en alliage SnBiAg (température de fusion plus faible).

Ensuite, à l'étape S32 de la figure 16B, des fils électriques 20 sont soudés aux doigts de collecte 12 de chaque cellule photovoltaïque 50 à l'aide des plots de soudure 36. Les fils électriques 20 sont d'abord mis en contact avec les plots de soudure 36 puis la pâte à souder est fondue par chauffage, par exemple à une température de 200 °C environ (pâte à braser type SnPb/SnPbAg) ou de 150 °C environ (pâte à braser type SnBiAg). Les plots de soudure 36 suffisent à former une connexion électrique durable et peu résistive entre les fils électriques 20 et les doigts de collecte 12. Ainsi, dans ce troisième mode de mise en œuvre, les fils électriques 20 ne sont pas nécessairement revêtus d'un alliage fusible à basse température. Utiliser des fils non-revêtus (i.e. formés d'un seul métal), par exemple uniquement en cuivre, réduit le coût de fabrication de la chaîne photovoltaïque.

Sur la figure 16B, les fils électriques 20 ont une longueur suffisante pour interconnecter tous les doigts de collecte 12 de la cellule. Les doigts de collecte 12 (interconnectés) sont par ailleurs reliés électriquement à la piste conductrice d'interconnexion 31 grâce aux premiers conducteurs de liaison 32.

Enfin, plusieurs cellules photovoltaïques 50 munies chacune des fils électriques 20 sont interconnectées en « shingle » lors d'une étape S33 illustrée par la figure 16C. Comme dans cet exemple les fils électriques 20 ne s'étendent pas jusqu'à la piste conductrice d'interconnexion 31, et donc dans la zone de recouvrement, la quantité d'adhésif électriquement conducteur 35 nécessaire pour interconnecter deux cellules photovoltaïques 50 peut être minimisée. Les fils électriques ont dans cet exemple un diamètre inférieur ou égal à 150 $\mu$m, de préférence compris entre 75 $\mu$m et 125 $\mu$m.

Comme représenté sur la figure 16C, des plots de soudure peuvent être également formés sur les doigts de collecte présents en face arrière des cellules photovoltaïques 50 afin d'y connecter des fils électriques 20 (cas des cellules bifaciales).

Après l'étape S31 de dépôt de la pâte à souder et avant l'étape S32 de soudure des fils électriques 20 sur les doigts de collecte 12, le procédé de fabrication peut comprendre une étape consistant à pré-fusionner les plots de soudure 36. Cette étape de pré-fusion tend à uniformiser le volume de soudure attaché aux doigts de collecte 12. Autrement dit, la pâte à souder se répartit de manière plus uniforme sur les doigts de collecte 12. Un volume de soudure constant permet d'homogénéiser la qualité des interconnexions.

A l'inverse, lorsqu'un plot de soudure 36 est fusionné pour la première fois en présence d'un fil électrique 20, la pâte à souder se répartit entre le doigt de collecte 12 et le fil électrique 20. Comme cette répartition est variable, on obtient des volumes de soudure attachés aux doigts de collecte 12 qui varient d'un plot de soudure à l'autre.

Les étapes de dépôt de pâte à souder et de préfusion des plots de soudure peuvent être accomplies sur chacune des cellules photovoltaïques 50, comme cela est représenté par la figure 16A, ou sur des cellules photovoltaïques de pleine taille avant leur découpage.

En fondant, la pâte à souder peut déborder des doigts de collecte 12 sur le substrat des cellules photovoltaïques. La zone de débordement, c'est-à-dire la zone du substrat recouverte pas la pâte à souder fondue, est variable en fonction des plots de soudure (à cause notamment des différences de volume de pâte déposés, des différences dans le désalignement par rapport au doigt de collecte lors du dépôt de la pâte à souder et des différences de mouillabilité entre les doigts de collecte). Les zones de débordement de la pâte à souder ne causent donc pas le même ombrage d'une cellule à l'autre, ce qui se traduit par des courants électriques différents entre les cellules. Ainsi, en cas de pré-fusion des plots de soudure 36, le procédé de fabrication comprend avantageusement une étape de tri des cellules photovoltaïques sur la base des caractéristiques I-V. Les cellules photovoltaïques peuvent être ainsi groupées par valeurs de courant, dans le but de maximiser le courant des chaînes photovoltaïques. Le tri I-V est de préférence réalisé après le découpage des cellules photovoltaïques de pleine taille, autrement dit avec les cellules photovoltaïques 50, car le débordement de la pâte à souder à un impact plus important sur des cellules de petite taille.

Les figures 17A à 17C représentent une variante de mise en œuvre du procédé de fabrication décrit en relation avec les figures 16A-16C. Dans cette variante de mise en œuvre, des cellules photovoltaïques 50 selon le mode de réalisation de la figure 5 peuvent être utilisées.

La pâte à souder est déposée, à l'étape S31' de la figure 17A, de façon à former, en plus des plots de soudure 36 alignés sur les doigts de collecte 12, des plots de soudure additionnels 36' alignés sur la piste conductrice d'interconnexion 31. Les plots de soudure additionnels 36' sont situés dans le prolongement des pistes de connexion discontinues formées par les plots de soudure 36.

Il est alors possible de prolonger les fils électriques 20 jusqu'à la piste conductrice d'interconnexion 31, pour qu'ils soient soudés avec celle-ci lors d'une étape S32' (cf. Fig.17B).

Enfin, les cellules photovoltaïques 50 sont interconnectées sous la forme d'une chaîne de cellules « shingle », au moyen d'un adhésif électriquement conducteur 35 disposé dans les zones de recouvrement des cellules.

Les fils électriques 20 utilisés dans cette variante de mise en œuvre du procédé de fabrication sont de préférence de diamètre plus faible que ceux utilisés précédemment lors des étapes S31-S33, avantageusement de diamètre inférieur à 100 $\mu$m. Cela permet de limiter la quantité d'adhésif électriquement conducteur utilisée, malgré la surépaisseur liée au fils électriques 20 situés dans les zones de recouvrement.

Dans le troisième mode de mise en œuvre du procédé de fabrication (Figs.16A-16C) comme dans la variante de mise en œuvre décrite en référence aux figures 17A-17C, des rubans électriques peuvent être utilisés comme éléments de connexion à la place des fils électriques 20. Toutefois, ils sont moins avantageux en termes d'ombrage (et donc de courant généré) en raison de leur section rectangulaire (les fils électriques, de section circulaire, ont un ombrage effectif sur la cellule photovoltaïque égal à 70 % seulement de leur diamètre, contre 100 % de la largeur des rubans).

Alors que les fils et rubans constituent dans les chaînes de cellules classiques (hors chaînes de cellules « shingle » qui sont dépourvues de tels fils ou rubans) des éléments dits « d'interconnexion » servant à interconnecter les cellules, ils sont utilisés ici pour connecter les doigts de collecte entre eux et éventuellement à la piste conductrice d'interconnexion au sein même de chaque cellule.

La figure 18 montre par ailleurs qu'une grille métallique peut être utilisée à la place des fils électriques 20 lors de l'étape S32 ou S32'. Cette grille métallique comprend par exemple une pluralité de premiers fils 22 parallèles entre eux, destinés à être soudés aux doigts de collecte 12 par l'intermédiaire des plots de soudure 36, et une pluralité de deuxièmes fils 23 reliant les premiers fils 22 entre eux à leurs extrémités. La grille métallique, formée par exemple d'argent ou de cuivre, présente avantageusement une épaisseur comprise entre 70 $\mu$m et 100 $\mu$m lorsqu'elle n'atteint pas la zone de recouvrement (cf. Fig.18) et une épaisseur comprise entre 35 $\mu$m et 70 $\mu$m lorsqu'elle atteint la zone de recouvrement (non représenté).

Dans un autre mode de mise en œuvre du procédé de fabrication, non représenté par les figures, des cellules photovoltaïques 50 munies de plots de soudure 36 (cf. Fig.16A ou 17A) sont d'abord interconnectées pour former une chaîne de cellule « shingle », puis des fils électriques continus (diamètre < 100 $\mu$m, sans film support, avec ou sans revêtement) sont soudés aux doigts de collecte des cellules photovoltaïques 50 par fusion des plots de soudure 36 (pré-fusionnés ou non). Après leur soudage, les fils électriques sont découpés en les pressant contre les arêtes saillantes des cellules photovoltaïques 50, par exemple à l'aide d'un rouleau.

De manière générale, le procédé de fabrication de chaînes photovoltaïques selon un aspect de l'invention comprend les étapes suivantes :

- fournir des première et deuxième cellules photovoltaïques 50 selon l'un quelconque des modes de réalisation représentés par les figures 5 à 11 ;
- interconnecter (étapes S12-S13 des figures 12B-12C ; étapes S22-S23 des figures 15B-15C ; étapes S31-S32 des figures 16A-16B ; étapes S31'-S32' des figures 17A-17B) dans chacune des cellules photovoltaïques 50 une partie au moins des doigts de collecte 12 par des éléments de connexion 20, 20', 22 en forme de fils ou de rubans déposés sur la face avant ;
- interconnecter (étape S11 de la figure 12A, étape S21 de la figure 15A, étape S33 de la figure 16C, étape S33' de la figure 17C) les cellules photovoltaïques 50, en recouvrant avec la face arrière de la deuxième cellule photovoltaïque une portion de la face avant de la première cellule photovoltaïque dans laquelle se situe la piste conductrice d'interconnexion 31.

Dans les premier et deuxième modes de mise en œuvre du procédé (Figs.12A-12C & 15A-15C), les éléments de connexion 20, 20' sont déposés sur la face avant des cellules photovoltaïques 50 après l'étape d'interconnexion des cellules photovoltaïques 50. Dans le troisième mode de mise en œuvre du procédé et sa variante (Figs.16A-16C & 17A-17C), les éléments de connexion 20 sont déposés (sur la face avant des cellules photovoltaïques 50 avant l'étape d'interconnexion des cellules photovoltaïques 50. Dans ce cas, il peut être également considéré que l'interconnexion des doigts de collecte par les éléments de connexion dans chaque cellule photovoltaïque 50 fait partie du procédé de fabrication de la cellule photovoltaïque.

Dans les chaînes photovoltaïques décrites ci-dessus et représentées par les figures 12C, 13-14, 15C, 16C et 17C, le courant électrique circule au sein de chaque cellule photovoltaïque 50 principalement par des éléments de connexion (par exemple de type fil) qui sont bien moins résistifs que les doigts de collecte (0,02 $\Omega$ pour 1 cm de fil de cuivre de diamètre 100 $\mu$m, contre 0,4 $\Omega$ à 8 $\Omega$ pour 1 cm de doigt de collecte suivant la géométrie). En effet, une fois extraits du substrat, les porteurs de charge ne transitent par les doigts de collecte que sur une faible distance, pour atteindre l'élément de connexion le plus proche. Cette faible distance de parcours dans les doigts de collecte autorise la formation de doigts de collecte plus résistifs (de préférence 2 $\Omega$ à 7 $\Omega$), c'est-à-dire de plus faible section et/ou formés avec une pâte moins conductrice (et donc moins riche en argent), sans que cela ne détériore la résistance série de la cellule une fois interconnectée. Par exemple, la section des doigts de collecte dans la cellule photovoltaïque 50 peut être égale à 45 $\mu$m x 6 $\mu$m, contre 70 $\mu$m x 15 $\mu$m dans la cellule photovoltaïque « shingle » 30 de l'art antérieur (cf. Fig.3). La consommation totale d'argent par cellule photovoltaïque 50 bifaciale peut être inférieure à 100 mg, contre plus de 300 mg pour la cellule photovoltaïque 30 de l'art antérieur. La cellule photovoltaïque 50 est par conséquent moins coûteuse à fabriquer. Par ailleurs, les doigts de collecte étant moins épais, ils peuvent être imprimés en une seule passe (au lieu de deux habituellement), ce qui contribue aussi à diminuer le coût d'une cellule.

Les pertes résistives liées au transport dans les doigts de collecte et les éléments de connexion sont moins importantes dans la chaîne photovoltaïque de l'invention que dans la chaîne de cellules « shingle » de l'art antérieur (dépourvue d'éléments de connexion). Le facteur de forme (FF, pour « Fill Factor » en anglais) d'un module fabriqué à partir des chaînes photovoltaïques selon l'invention sera donc meilleur que celui d'un module « shingle » selon l'art antérieur.

Ces bénéfices sont particulièrement intéressants pour la formation de chaînes de cellules à hétérojonction de silicium (SHJ), car ce type de cellules photovoltaïques est pénalisé par une consommation d'argent plus importante que celle des cellules à homojonction (HMJ). En effet, les pâtes de sérigraphie compatibles avec le procédé de fabrication « basse température » des cellules à hétérojonction sont (pour une même quantité d'argent) moins conductrices électriquement (résistivité de 2-2,5 $\mu\Omega$.cm pour les pâtes haute température et 4-7 $\mu\Omega$.cm pour les pâtes haute température).

Les doigts de collecte de la cellule photovoltaïque 50 ayant une section réduite, ils occasionnent moins d'ombrage sur la face avant de la cellule. L'ombrage supplémentaire causé par les fils électriques (absents de la cellule photovoltaïque « shingle » 30 de l'art antérieur) est faible, compte tenu du faible diamètre des fils (< 100 $\mu$m) et de leur taux d'ombrage effectif réduit (70 % du diamètre). Cet ombrage supplémentaire est inférieur à la diminution de l'ombrage liée à la plus faible section des doigts de collecte. Ainsi, en orientant les doigts de collecte de façon à pouvoir les interconnecter par des fils, on diminue globalement l'ombrage sur la face avant de la cellule ce qui se traduit par un gain en courant.

Comme la résistance liée au transport du courant diminue, il est avantageux de former des chaînes avec des tuiles de plus grande superficie (et donc de plus grand courant), par exemple des tiers ou des quarts de cellule photovoltaïque de pleine taille plutôt que des cinquièmes ou des sixièmes de cellule photovoltaïque de pleine taille. Ainsi, les pertes par recombinaison de paires électron-trou au niveau des bords découpés (et non passivés) des tuiles sont diminuées.

Enfin, les chaînes photovoltaïques de l'invention présentent les avantages de la technique d'interconnexion « shingle » classique, en termes de surface active et de rendement module notamment.

**Revendications**

1. Cellule photovoltaïque (50) comprenant une face avant destinée à être exposée à un rayonnement incident et une face arrière opposée à la face avant, la face avant présentant :

   - une pluralité d'électrodes parallèles entre elles et appelées doigts de collecte (12) ;
   - une piste conductrice d'interconnexion (31) de largeur supérieure à la largeur des doigts de collecte (12), s'étendant parallèlement à un bord (51) de la cellule photovoltaïque (50) à moins de 2 mm dudit bord de la cellule photovoltaïque, les doigts de collecte (12) étant orientés par rapport à la piste conductrice d'interconnexion (31) d'un angle ($\alpha$, $\beta$) compris entre -65° et 65 ;

   cellule photovoltaïque **caractérisée en ce qu'**une partie au moins des doigts de collecte (12) sont interconnectés par des éléments de connexion (20, 20', 22-23) en forme de fils ou de rubans, les éléments de connexion étant disposés sur ladite au moins une partie des doigts de collecte de la face avant.

2. Cellule photovoltaïque (50) selon la revendication 1, dans laquelle les éléments de connexion (20, 20', 22) sont orientés perpendiculairement à la piste conductrice d'interconnexion (31).

3. Cellule photovoltaïque (50) selon l'une des revendications 1 et 2, dans laquelle les doigts de collecte (12) sont orientés parallèlement à la piste conductrice d'interconnexion (31).

4. Cellule photovoltaïque (50) selon l'une des revendications 1 à 3, comprenant en outre des premiers conducteurs de liaison (32) reliant électriquement la piste conductrice d'interconnexion (31) au doigt de collecte (12) le plus proche de la piste conductrice d'interconnexion.

5. Cellule photovoltaïque (50) selon la revendication 4, comprenant en outre des deuxièmes conducteurs de liaison (33) reliant électriquement entre eux les deux doigts de collecte (12) les plus éloignés de la piste conductrice d'interconnexion (31).

6. Cellule photovoltaïque (50) selon l'une des revendications 4 et 5, comprenant en outre des troisièmes conducteurs de liaison (34) reliant électriquement entre eux les deux doigts de collecte (12) les plus proches de la piste conductrice d'interconnexion (31).

7. Cellule photovoltaïque (50) selon l'une quelconque des revendications 1 à 6, comprenant en outre une pluralité de premiers plots de soudure (36) alignés sur les doigts de collecte (12) et formant, perpendiculairement aux doigts de collecte, une pluralité de pistes de connexion discontinues.

8. Cellule photovoltaïque selon la revendication 7, dans laquelle les éléments de connexion (20) sont fixés aux doigts de collecte (12) par l'intermédiaire des pistes de connexion discontinues.

9. Cellule photovoltaïque selon la revendication 8, comprenant en outre une pluralité de deuxièmes plots de soudure (36') alignés sur la piste conductrice d'interconnexion (31), dans le prolongement des pistes de connexion discontinues, les éléments de connexion (20) étant en outre fixés à la piste conductrice d'interconnexion (31) par l'intermédiaire des deuxièmes plots de soudure (36').

10. Cellule photovoltaïque (50) selon l'une quelconque des revendications 1 à 9, dans laquelle au moins un des doigts de collecte (12) interconnectés est relié électriquement à la piste conductrice d'interconnexion (31).

11. Chaîne photovoltaïque comprenant des première et deuxième cellules photovoltaïques (50) selon l'une quelconque des revendications 1 à 10, la deuxième cellule photovoltaïque étant interconnectée avec la première cellule photovoltaïque en recouvrant avec la face arrière de la deuxième cellule photovoltaïque une portion de la face avant de la première cellule dans laquelle se situe la piste conductrice d'interconnexion (31).

12. Chaîne photovoltaïque selon la revendication 11, dans laquelle les éléments de connexion (20) s'étendent jusqu'à la piste conductrice d'interconnexion (31).

13. Procédé de fabrication d'une cellule photovoltaïque comprenant les étapes suivantes :

   - former sur une face d'un substrat une pluralité d'électrodes parallèles entre elles, appelées doigts de collecte (12), et une piste conductrice d'interconnexion (31) de largeur supérieure à la largeur des doigts de collecte (12), la piste conductrice d'interconnexion (31) s'étendant parallèlement à un bord du substrat à moins de 2 mm dudit bord du substrat et les doigts de collecte (12) étant orientés par rapport à la piste conductrice d'interconnexion d'un angle compris entre -65° et 65° ;
   - interconnecter une partie au moins des doigts de collecte (12) par des éléments de connexion (20, 20', 22-23) en forme de fils ou de rubans, les éléments de connexion (20, 20', 22-23) étant déposés sur ladite au moins une partie des doigts de collecte.

**14.** Procédé de fabrication d'une chaîne photovoltaïque comprenant les étapes suivantes :

- fournir des première et deuxième cellules photovoltaïques (50) comprenant chacune une face avant destinée à être exposée à un rayonnement incident et une face arrière opposée à la face avant, la face avant présentant :

◦ une pluralité d'électrodes parallèles entre elles et appelées doigts de collecte (12) ;
◦ une piste conductrice d'interconnexion (31) de largeur supérieure à la largeur des doigts de collecte (12), s'étendant parallèlement à un bord (51) de la cellule photovoltaïque (50) à moins de 2 mm dudit bord de la cellule photovoltaïque, les doigts de collecte (12) étant orientés par rapport à la piste conductrice d'interconnexion (31) d'un angle ($\alpha$, $\beta$) compris entre -65° et 65° ;

- interconnecter (S12-S13, S22-S23, S31-S32, S32') dans chacune des première et deuxième cellules photovoltaïques (50) une partie au moins des doigts de collecte (12) par des éléments de connexion (20, 20', 22-23) en forme de fils ou de rubans, les éléments de connexion (20, 20', 22-23) étant déposés sur ladite au moins une partie des doigts de collecte de la face avant ;
- interconnecter (S11, S21, S33, S33') la deuxième cellule photovoltaïque avec la première cellule photovoltaïque, en recouvrant avec la face arrière de la deuxième cellule photovoltaïque une portion de la face avant de la première cellule photovoltaïque dans laquelle se situe la piste conductrice d'interconnexion (31).

**15.** Procédé selon la revendication 14, dans lequel les éléments de connexion sont déposés (S13, S23) sur la face avant des première et deuxième cellules photovoltaïques (50) après l'étape d'interconnexion (S11, S21) des première et deuxième cellules photovoltaïques (50).

**16.** Procédé selon la revendication 15, comprenant les opérations suivantes :

- fournir (S12, S22) des fils électriques (20) solidaires d'un film support (40) ;
- découper (S12, S23) les fils électriques (20) en segments de fils électriques (20') de longueur (L) inférieure à la largeur (l) des première et deuxième cellules photovoltaïques (50) ; et
- plaquer (S13, S23) le film support (40) contre la face avant des première et deuxième cellules photovoltaïques (50) de façon à mettre en contact les fils électriques (20, 20') avec les doigts de collecte (12).

**17.** Procédé selon la revendication 14, dans lequel les éléments de connexion (20) sont déposés (S32, S32') sur la face avant des première et deuxième cellules photovoltaïques (50) avant l'étape d'interconnexion (S33, S33') des première et deuxième cellules photovoltaïques (50).

**Patentansprüche**

**1.** Photovoltaikzelle (50) mit einer Vorderseite, die dazu bestimmt ist, einfallender Strahlung ausgesetzt zu werden, und einer der Vorderseite gegenüberliegenden Rückseite, wobei die Vorderseite aufweist:

- eine Vielzahl von zueinander parallelen Elektroden, die als Sammelfinger (12) bezeichnet werden;
- eine Verbindungsleiterbahn (31) mit einer Breite, die größer ist als die Breite der Sammelfinger (12), die sich parallel zu einer Kante (51) der Photovoltaikzelle (50) in einem Abstand von weniger als 2 mm von der Kante der Photovoltaikzelle erstreckt, wobei die Sammelfinger (12) in Bezug auf die Verbindungsleiterbahn (31) in einem Winkel ($\alpha$, $\beta$) zwischen -65° und 65° ausgerichtet sind;

Photovoltaikzelle, **dadurch gekennzeichnet, dass** mindestens ein Teil der Sammelfinger (12) durch draht- oder bandförmige Verbindungselemente (20, 20', 22, 23) miteinander verbunden sind, wobei die Verbindungselemente auf dem mindestens einen Teil der Sammelfinger der Vorderseite angeordnet sind.

**2.** Photovoltaikzelle (50) nach Anspruch 1, bei der die Verbindungselemente (20, 20', 22) senkrecht zur Verbindungsleiterbahn (31) ausgerichtet sind.

**3.** Photovoltaikzelle (50) nach einem der Ansprüche 1 und 2, bei der die Sammelfinger (12) parallel zur Verbindungsleiterbahn (31) ausgerichtet sind.

**4.** Photovoltaikzelle (50) nach einem der Ansprüche 1 bis 3, die außerdem erste Verbindungsleiter (32) umfasst, die die Verbindungsleiterbahn (31) elektrisch mit dem Sammelfinger (12) verbinden, der der Verbindungsleiterbahn am nächsten liegt.

**5.** Photovoltaikzelle (50) nach Anspruch 4, die außerdem zweite Verbindungsleiter (33) umfasst, die die beiden von der Verbindungsleiterbahn (31) am weitesten entfernten Sammelfinger (12) elektrisch miteinander verbinden.

6. Photovoltaikzelle (50) nach einem der Ansprüche 4 und 5, die außerdem dritte Verbindungsleiter (34) umfasst, die die beiden Sammelfinger (12), die der Verbindungsleiterbahn (31) am nächsten liegen, elektrisch miteinander verbinden.

7. Photovoltaikzelle (50) nach einem der Ansprüche 1 bis 6, die außerdem mehrere erste Lötpads (36) umfasst, die auf den Sammelfingern (12) ausgerichtet sind und senkrecht zu den Sammelfingern mehrere unterbrochene Verbindungsbahnen bilden.

8. Photovoltaikzelle nach Anspruch 7, bei der die Verbindungselemente (20) über die unterbrochenen Verbindungsbahnen an den Sammelfingern (12) befestigt sind.

9. Photovoltaikzelle nach Anspruch 8, die außerdem mehrere zweite Lötpads (36') umfasst, die auf der Verbindungsleiterbahn (31) ausgerichtet sind, in Verlängerung der unterbrochenen Verbindungsbahnen, wobei die Verbindungselemente (20) außerdem über die zweiten Lötpads (36') an der Verbindungsleiterbahn (31) befestigt sind.

10. Photovoltaikzelle (50) nach einem der Ansprüche 1 bis 9, bei der mindestens einer der miteinander verbundenen Sammelfinger (12) elektrisch mit der Verbindungsleiterbahn (31) verbunden ist.

11. Photovoltaikkette mit ersten und zweiten Photovoltaikzellen (50) gemäß einem der Ansprüche 1 bis 10, wobei die zweite Photovoltaikzelle mit der ersten Photovoltaikzelle so verbunden ist, dass die Rückseite der zweiten Photovoltaikzelle einen Teil der Vorderseite der ersten Photovoltaikzelle überlappt, in dem sich die Verbindungsleiterbahn (31) befindet.

12. Photovoltaikkette nach Anspruch 11, bei der sich die Verbindungselemente (20) bis zur Verbindungsleiterbahn (31) erstrecken.

13. Verfahren zur Herstellung einer Photovoltaikzelle, das die folgenden Schritte umfasst:

- Bilden auf einer Seite eines Trägers einer Vielzahl von zueinander parallelen Elektroden, die als Sammelfinger (12) bezeichnet werden, und einer Verbindungsleiterbahn (31), deren Breite größer ist als die Breite der Sammelfinger (12), wobei die Verbindungsleiterbahn (31) parallel zu einer Kante des Trägers in einem Abstand von weniger als 2 mm von dieser Kante verläuft und die Sammelfinger (12) in einem Winkel zwischen -65° und 65° zur Verbindungsleiterbahn ausgerichtet sind;
- Verbinden mindestens eines Teils der Sammelfinger (12) durch draht- oder bandförmige Verbindungselemente (20, 20', 22-23), wobei die Verbindungselemente (20, 20', 22-23) auf dem mindestens einen Teil der Sammelfinger aufgebracht sind.

14. Verfahren zur Herstellung einer Photovoltaikkette, das die folgenden Schritte umfasst:

- Bereitstellen einer ersten und einer zweiten Photovoltaikzelle (50), die jeweils eine Vorderseite, die der einfallenden Strahlung ausgesetzt ist, und eine der Vorderseite gegenüberliegende Rückseite aufweisen, wobei die Vorderseite aufweist:

  ◦ eine Vielzahl von zueinander parallelen Elektroden, die als Sammelfinger (12) bezeichnet werden;
  ◦ eine Verbindungsleiterbahn (31) mit einer Breite, die größer ist als die Breite der Sammelfinger (12), die sich parallel zu einer Kante (51) der Photovoltaikzelle (50) in einem Abstand von weniger als 2 mm von der Kante der Photovoltaikzelle erstreckt, wobei die Sammelfinger (12) in Bezug auf die Verbindungsleiterbahn (31) in einem Winkel ($\alpha,\beta$) zwischen -65° und 65° ausgerichtet sind;

- Verbinden (S12-S13, S22-S23, S31-S32, S32') in jeder der ersten und zweiten Photovoltaikzellen (50) mindestens eines Teils der Sammelfinger (12) durch draht- oder bandförmige Verbindungselemente (20, 20', 22-23), wobei die Verbindungselemente (20, 20', 22-23) auf dem mindestens einen Teil der Sammelfinger der Vorderseite aufgebracht sind,
- Verbinden der zweiten Photovoltaikzelle mit der ersten Photovoltaikzelle (S11, S21, S33, S33'), wobei die Rückseite der zweiten Photovoltaikzelle einen Teil der Vorderseite der ersten Photovoltaikzelle überdeckt, in dem sich die Verbindungsleiterbahn (31) befindet.

15. Verfahren nach Anspruch 14, bei dem die Verbindungselemente nach dem Verbindungsschritt (S11, S21) der ersten und zweiten Photovoltaikzellen (50) auf der Vorderseite der ersten und zweiten Photovoltaikzellen (50) aufgebracht werden (S13, S23).

16. Verfahren nach Anspruch 15, die folgenden Schritte umfassend:

- Bereitstellen (S12, S22) von elektrischen Drähten (20), die fest mit einer Trägerfolie (40) verbunden sind;
- Schneiden (S12, S23) der elektrischen Drähte (20) in elektrische Drahtsegmente (20') mit einer Länge (L), die kleiner ist als die Breite (I) der ersten und zweiten Photovoltaikzellen (50); und
- Aufbringen (S13, S23) der Trägerfolie (40) auf die Vorderseite der ersten und zweiten Photovoltaikzellen (50), so dass die elektrischen Drähte (20, 20') mit den Sammelfingern (12) in Kontakt kommen.

**17.** Verfahren nach Anspruch 14, bei dem die Verbindungselemente (20) vor dem Schritt des Verbindens (S33, S33') der ersten und zweiten Photovoltaikzellen (50) auf der Vorderseite der ersten und zweiten Photovoltaikzellen (50) aufgebracht werden (S32, S32').


**Claims**

**1.** Photovoltaic cell (50) comprising a front face intended to be exposed to an incident radiation and a rear face opposite to the front face, the front face having:

- a plurality of electrodes parallel with each other and called collection fingers (12);
- an interconnection conductive track (31) of width greater than the width of the collection fingers (12), extending parallel to an edge (51) of the photovoltaic cell (50) at less than 2 mm from said edge of the photovoltaic cell, the collection fingers (12) being oriented with respect to the interconnection conductive track (31) by an angle ($\alpha$, $\beta$) comprised between -65° and 65°;

photovoltaic cell **characterised in that** a part at least of the collection fingers (12) are interconnected by connection elements (20, 20', 22-23) in the form of wires or ribbons arranged on the front face, connection elements being arranged on said part at least of the collection fingers of the front face.

**2.** Photovoltaic cell (50) according to claim 1, wherein the connection elements (20, 20', 22) are oriented perpendicularly to the interconnection conductive track (31).

**3.** Photovoltaic cell (50) according to one of claims 1 and 2, wherein the collection fingers (12) are oriented parallel to the interconnection conductive track (31).

**4.** Photovoltaic cell (50) according to one of claims 1 to 3, further comprising first connecting conductors (32) electrically connecting the interconnection conductive track (31) to the collection finger (12) the closest to the interconnection conductive track.

**5.** Photovoltaic cell (50) according to claim 4, further comprising second connecting conductors (33) electrically connecting together the two collection fingers (12) the furthest away from the interconnection conductive track (31).

**6.** Photovoltaic cell (50) according to one of claims 4 and 5, further comprising third connecting conductors (34) electrically connecting together the two collection fingers (12) the closest to the interconnection conductive track (31).

**7.** Photovoltaic cell (50) according to any one of claims 1 to 6, further comprising a plurality of first solder pads (36) aligned on the collection fingers (12) and forming, perpendicularly to the collection fingers, a plurality of discontinuous connection tracks.

**8.** Photovoltaic cell according to claim 7, wherein the connection elements (20) are fixed to the collection fingers (12) through discontinuous connection tracks.

**9.** Photovoltaic cell according to claim 8, further comprising a plurality of second solder pads (36') aligned on the interconnection conductive track (31), in the extension of the discontinuous connection tracks, the connection elements (20) being further fixed to the interconnection conductive track (31) through second solder pads (36').

**10.** Photovoltaic cell (50) according to any one of claims 1 to 9, wherein at least one of the interconnected collection fingers (12) is electrically connected to the interconnection conductive track (31).

**11.** Photovoltaic string comprising first and second photovoltaic cells (50) according to any one of claims 1 to 10, the second photovoltaic cell being interconnected with the first photovoltaic cell by overlapping with the rear face of the second photovoltaic cell a portion of the front face of the first cell wherein is situated the interconnection conductive track (31).

**12.** Photovoltaic string according to claim 11, wherein the connection elements (20) extend up to the interconnection conductive track (31).

**13.** Method for manufacturing a photovoltaic cell comprising the following steps:

- forming on a face of a substrate a plurality of electrodes parallel with each other, called collection fingers (12), and an interconnection conductive track (31) of width greater than the width of the collection fingers (12), the interconnection conductive track (31) extending parallel to an edge of the substrate at less than 2 mm from said edge of the substrate and the collection fingers (12) being oriented with respect to the interconnection conductive track by an angle comprised between -65° and 65°;

- interconnecting a part at least of the collection fingers (12) by connection elements (20, 20', 22-23) in the form of wires or ribbons, connection elements (20, 20', 22-23) being arranged on said part at least of the collection fingers.

14. Method for manufacturing a photovoltaic string comprising the following steps:

- providing first and second photovoltaic cells (50) each comprising a front face intended to be exposed to an incident radiation and a rear face opposite to the front face, the front face having:

  ○ a plurality of electrodes parallel with each other and called collection fingers (12);
  ○ an interconnection conductive track (31) of width greater than the width of the collection fingers (12), extending parallel to an edge (51) of the photovoltaic cell (50) at less than 2 mm from said edge of the photovoltaic cell, the collection fingers (12) being oriented with respect to the interconnection conductive track (31) by an angle ($\alpha$, $\beta$) comprised between -65° and 65°;

- interconnecting (S12-S13, S22-S23, S31-S32, S32') in each of the first and second photovoltaic cells (50) a part at least of the collection fingers (12) by connection elements (20, 20', 22-23) in the form of wires or ribbons deposited on the front face, connection elements being arranged on said part at least of the collection fingers of the front face;
- interconnecting (S11, S21, S33, S33') the second photovoltaic cell with the first photovoltaic cell, by overlapping with the rear face of the second photovoltaic cell a portion of the front face of the first photovoltaic cell wherein is situated the interconnection conductive track (31).

15. Method according to claim 14, wherein the connection elements are deposited (S13, S23) on the front face of the first and second photovoltaic cells (50) after the step of interconnecting (S11, S21) the first and second photovoltaic cells (50).

16. Method according to claim 15, comprising the following operations:

- providing (S12, S22) electric wires (20) integral with a support film (40);
- cutting (S12, S23) the electric wires (20) into segments of electric wires (20') of length (L) less than the width (I) of the first and second photovoltaic cells (50); and
- pressing (S13, S23) the support film (40) against the front face of the first and second photovoltaic cells (50) in such a way as to place in contact the electric wires (20, 20') with the collection fingers (12).

17. Method according to claim 14, wherein the connection elements (20) are deposited (S32, S32') on the front face of the first and second photovoltaic cells (50) before the step of interconnecting (S33, S33') the first and second photovoltaic cells (50).

**Fig.1**

**Fig.2**

**Fig.3A**

**Fig.3B**

**Fig.4A**

**Fig.4B**

**Fig.5**

**Fig.6**

**Fig.7**

**Fig.8**

**Fig.9**

**Fig.10**

**Fig.11**

-S11-

-S12-

**Fig.12A**

**Fig.12B**

-S13-

**Fig.12C**

**Fig.13**

**Fig.14**

**Fig.15A**

**Fig.15B**

**Fig.15C**

-S31-

**Fig.16A**

-S32-

**Fig.16B**

-S33-

**Fig.16C**

-S31'-

**Fig.17A**

-S32'-

**Fig.17B**

-S33'-

**Fig.17C**

**Fig.18**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017194516 A1

**Littérature non-brevet citée dans la description**

- **S. BRAUN et al.** Multi-busbar solar cells and modules: high efficiencies and low silver consumption. *Energy Procedia*, 2013, vol. 38, 334-339
- **T. SÖDERSTRÖM et al.** Smart Wire Connection Technology. *Proceedings of the 28th European Photovoltaics Solar Energy Conference*, 2013, 495-499
- Materials challenge for shingled cells interconnection. **G. BEAUCARNE**. Energy Procedia. 2016, vol. 98, 115-124